# EUROPEAN PATENT APPLICATION

(11) **EP 2 626 205 A1**
(43) Date of publication of application: **14.08.2013**
(21) Application number: 11830746.1
(22) Date of filing: 06.10.2011
(51) Int. Cl.: B32B 27/38, B32B 27/20, C08K 3/38, C08L 63/00, H01L 23/373

(54) **MULTILAYER RESIN SHEET AND PROCESS FOR PRODUCTION THEREOF, RESIN SHEET LAMINATE AND PROCESS FOR PRODUCTION THEREOF, CURED MULTILAYER RESIN SHEET, METAL-FOIL-CLADDED MULTILAYER RESIN SHEET, AND SEMICONDUCTOR DEVICE**

(30) Priority: 06.10.2010 JP 2010226601
(71) Applicant: Hitachi Chemical Co., Ltd., Chiyoda-ku Tokyo 100-6606 (JP)
(72) Inventor: NISHIYAMA, Tomoo, Tsukuba-shi Ibaraki 300-4247 (JP); TAKEZAWA, Yoshitaka, Tsukuba-shi Ibaraki 300-4247 (JP); KATAGI, Hideyuki, Tsukuba-shi Ibaraki 300-4247 (JP); HARA, Naoki, Chikusei-shi Ibaraki 308-8521 (JP); MIYAZAKI, Yasuo, Tsukuba-shi Ibaraki 300-4247 (JP); YOSHIHARA, Kensuke, Chikusei-shi Ibaraki 308-8521 (JP)
(74) Representative: HOFFMANN EITLE
(86) International application number: PCT/JP2011/073124
(87) International publication number: WO 2012/046814

(57) **Abstract**

A multilayer resin sheet including: a resin layer that includes an epoxy resin monomer, a curing agent, and a filler; and an adhesive layer positioned on at least one face of the resin layer, the filler having peaks in ranges of from 0.01 µm to less than 1 µm, from 1 µm to less than 10 µm, and from 10 µm to 100 µm, respectively, in terms of particle size distribution as measured by laser diffractometry, and the filler having a particle size of from 10 µm to 100 µm including a boron nitride filler.

## Description

### Technical Field

The present invention relates to a multilayer resin sheet and a method for production thereof, a resin sheet laminate and a method for production thereof, a cured multilayer resin sheet, a metal-foil-cladded multilayer resin sheet, and a semiconductor device.

### Background Art

As electronic devices employing semiconductor reduce in size, increase in capacity and improve in performance, the amount of heat generation from semiconductor devices that are packaged at high density has been increasing. For example, for stable operation of a semiconductor device used for controlling a central processing unit of a personal computer or a motor of an electric vehicle, it has become indispensable to provide a heat sink or a radiation fin for the purpose of heat radiation. Therefore, a material that is insulating and thermally conductive has been demanded as a member that connects a semiconductor device and a heat sink or the like.

Further, organic materials have been generally widely used as an insulating material that is used for a printed substrate or the like on which a semiconductor device or the like is mounted. Although organic materials are highly insulating, their contribution to heat radiation of semiconductor devices has not been significant due to insufficient thermal conductivity. There are cases in which inorganic materials such as inorganic ceramics are used for heat radiation of a semiconductor device or the like. Although inorganic materials are highly thermally conductive, insulation properties thereof are not sufficient as compared with organic materials. Accordingly, there is demand for a material that is highly insulating and highly thermally conductive.

In connection with the above, studies have been conducted with regard to a composite material of a resin and an inorganic filler having a high thermal conductivity that is referred to as a filler. For example, it is described that a cured material of a composite of a typical bisphenol A epoxy resin and an alumina filler achieves a thermal conductivity of 3.8 W/mK according to a xenon flash method or 4.5 W/mK according to a temperature wave analysis (for example, refer to Japanese Patent Application Laid-Open (JP-A) No. 2008-13759). Similarly, it is described that a cured material of a composite of a special epoxy resin, an amine curing agent and an alumina filler achieves a thermal conductivity of 9.4 W/mK according to a xenon flash method or 10.4 W/mK according to a temperature wave analysis (for example, refer to JP-A No. 2008-13759).

As a cured resin product that is even more thermally conductive, a thermally-conductive resin composition that includes boron nitride, an epoxy resin, an amine curing agent and a polymer component such as a curing catalyst is known. It is described that the composition achieves a thermal conductivity of from 6 W/mK to 11 W/mK according to a temperature wave analysis (for example, refer to JP-A No. 2008-189818). However, since boron nitride is a soft filler, there is a possibility that adhesive strength of a resin layer that includes boron nitride may decrease.

Furthermore, as a structure of an adhesive layer that is suitable for a power module, it is described that adhesive strength is maintained and occurrence of exfoliation or the like is suppressed by providing, on at least one face of a first adhesive layer containing a filler, a second adhesive layer that is formed substantially of an adhesive (for example, refer to JP-A No. 2009-21530). The publication does not describe physical properties or evaluation methods of the adhesive layer. However, in consideration of the fact that the adhesive layer does not include a filler, it is supposed that the thermal conductivity in a thickness direction of the sheet will significantly decrease, and that the adhesive strength will decrease since the second adhesive layer is made of a thermoplastic resin that is not adhesive with respect to metal in a chemical manner.

### DISCLOSURE OF INVENTION

### Technical Problem

As such, there have been cases in which it is difficult for the thermally-conductive cured resin disclosed in JP-A No. 2008-13759, JP-A No. 2008-189818 and JP-A No. 2009-21530 to satisfy all of thermal conductivity, adhesive strength and an insulation property at high levels.
It is an object of the present invention to provide a cured multilayer resin sheet that exhibits excellent thermal conductivity, adhesive strength and an insulation property; a resin sheet laminate and a method for producing the same; and a multilayer resin sheet from which the cured multilayer resin sheet can be formed.

### Solution to Problem

### The present invention includes the following aspects.

A first aspect of the present invention is a multilayer resin sheet that includes a resin layer that includes an epoxy resin monomer, a curing agent and a filler, and an adhesive layer positioned on at least one face of the resin layer, the filler having peaks in ranges of from 0.01 µm to less than 1 µm, from 1 µm to less than 10 µm, and from 10 µm to 100 µm, respectively, in terms of particle size distribution as measured by laser diffractometry, and the filler having a particle size of from 10 µm to 100 µm including a boron nitride filler.

Preferably, in the multilayer resin sheet, at least a part of the filler having a particle size of from 10 µm to 100 µm is embedded in the adhesive layer. Moreover, preferably, in the multilayer resin sheet, at least one of the epoxy resin monomer is an epoxy resin monomer having a mesogenic group, and at least one of the curing agent is a novolac resin. Furthermore, preferably, in the multilayer resin sheet, the adhesive layer includes at least one of a modified polyimide resin, a modified polyamide-imide resin and an epoxy resin.

A second aspect of the present invention is a multilayer resin sheet that includes a resin layer and an adhesive layer positioned on at least one face of the resin layer, the resin layer including an epoxy resin monomer, a curing agent, a first filler having a volume average particle size of from 0.01 µm to less than 1 µm, a second filler having a volume average particle size of from 1 µm to less than 10 µm, and a third filler having a volume average particle size of from 10 µm to 100 µm and including a boron nitride filler.

Preferably, in the multilayer resin sheet, at least a part of the third filler is embedded in the adhesive layer. Moreover, preferably, in the resin sheet, at least one of the epoxy resin monomer is an epoxy resin monomer having a mesogenic group, and at least one of the curing agent is a novolac resin. Furthermore, preferably, in the multilayer resin sheet, the adhesive layer includes at least one of a modified polyimide resin, a modified polyamide-imide resin and an epoxy resin.

A third aspect of the present invention is a cured multilayer resin sheet that includes a cured resin layer that includes a filler and a cured resin that includes a reactant of an epoxy resin monomer and a curing agent, and an adhesive layer positioned on at least one face of the cured resin layer, the filler having peaks in ranges of from 0.01 µm to less than 1 µm, from 1 µm to less than 10 µm, and from 10 µm to 100 µm, respectively, in terms of particle size distribution as measured by laser diffractometry, the filler having a particle size of from 10 µm to 100 µm including a boron nitride filler, and at least a part of the filler having a particle size of from 10 µm to 100 µm being embedded in the adhesive layer.

Preferably, in the cured multilayer resin sheet, at least a part of the filler having a particle size of from 10 µm to 100 µm is in contact with each other in the cured resin layer. Moreover, preferably, in the cured multilayer resin sheet, at least one of the epoxy resin monomer is an epoxy resin monomer having a mesogenic group, and at least one of the curing agent is a novolac resin. Furthermore, preferably, in the cured multilayer resin sheet, the adhesive layer includes at least one of a modified polyimide resin, a modified polyamide-imide resin and an epoxy resin.

A fourth aspect of the present invention is a cured multilayer resin sheet that includes a cured resin layer and an adhesive layer positioned on at least one face of the cured resin layer, the cured resin layer including a cured resin that includes a reactant of an epoxy resin monomer and a curing agent, a first filler having a volume average particle size of from 0.01 µm to less than 1 µm, a second filler having a volume average particle size of from 1 µm to less than 10 µm, and a third filler having a volume average particle size of from 10 µm to 100 µm and including a boron nitride filler, and at least a part of the third filler being embedded in the adhesive layer.

Preferably, in the cured multilayer resin sheet, at least a part of the third filler is in contact with each other in the cured resin layer. Moreover, preferably, in the cured multilayer resin sheet, at least one of the epoxy resin monomer is an epoxy resin monomer having a mesogenic group, and at least one of the curing agent is a novolac resin. Furthermore, preferably, in the cured multilayer resin sheet, the adhesive layer includes at least one of a modified polyimide resin, a modified polyamide-imide resin and an epoxy resin.

A fifth aspect of the present invention is a method for producing a multilayer resin sheet that includes: a step of obtaining a resin layer that includes an epoxy resin monomer, a curing agent, a first filler having a volume average particle size of from 0.01 µm to less than 1 µm, a second filler having a volume average particle size of from 1 µm to less than 10 µm, and a third filler having a volume average particle size of from 10 µm to 100 µm and including boron nitride; and a step of positioning an adhesive layer on at least one face of the resin layer and allowing at least a part of the third filler to be embedded in the adhesive layer.

A sixth aspect of the present invention is a resin sheet laminate that includes the cured multilayer resin sheet, and a metal plate or a radiator plate positioned on at least one face of the cured multilayer resin sheet.

A seventh aspect of the present invention is a method for producing a resin sheet laminate that includes: a step of obtaining a laminate by positioning a metal plate or a radiator plate on the adhesive layer of the multilayer resin sheet; and a step of allowing at least a part of the boron nitride filler to be embedded in the adhesive layer.

An eighth aspect of the present invention is a metal-foil-cladded multilayer resin sheet that includes the multilayer resin sheet and a metal foil positioned on the adhesive layer of the multilayer resin sheet.

A ninth aspect of the present invention is a semiconductor device that includes a semiconductor element and the cured multilayer resin sheet, the cured multilayer resin sheet being positioned on the semiconductor element.

### Effect of the Invention

According to the present invention, it is possible to provide a cured multilayer resin sheet that exhibits excellent thermal conductivity, adhesive strength and an insulation property and a method for producing the same; a highly thermally conductive resin sheet laminate and a method for producing the same; and a multilayer resin sheet from which the cured multilayer resin sheet can be formed.

### BRIEF DESCRIPTION OF DRAWINGS

Fig. 1 is a schematic cross-sectional diagram showing one example of a configuration of a resin layer according to the present invention.
Fig. 2 is a schematic cross-sectional diagram showing one example of a configuration of a cured multilayer resin sheet according to the present invention.
Fig. 3 is a schematic cross-sectional diagram showing one example of a configuration of a cured multilayer resin sheet having a configuration similar to embodiments of the present invention.
Fig. 4 is one example of a cross-sectional SEM photograph of a cured multilayer resin sheet according to the present invention.
Fig. 5 is one example of a cross-sectional SEM photograph of a cured multilayer resin sheet having a configuration similar to embodiments of the present invention.
Fig. 6 is a schematic cross-sectional diagram showing one example of a configuration of a power semiconductor device configured by using a multilayer resin sheet according to the present invention.
Fig. 7 is a schematic cross-sectional diagram showing one example of a configuration of a power semiconductor device configured by using a multilayer resin sheet according to the present invention.
Fig. 8 is a schematic cross-sectional diagram showing one example of a configuration of a power semiconductor device configured by using a multilayer resin sheet according to the present invention.
Fig. 9 is a schematic cross-sectional diagram showing one example of a configuration of an LED light bar configured by using a multilayer resin sheet according to the present invention.
Fig. 10 is a schematic cross-sectional diagram showing one example of a configuration of an LED bulb configured by using a multilayer resin sheet according to the present invention.
Fig. 11 is a schematic cross-sectional diagram showing one example of a configuration of an LED bulb configured by using a multilayer resin sheet according to the present invention.
Fig. 12 is a schematic cross-sectional diagram showing one example of a configuration of an LED substrate configured by using a multilayer resin sheet according to the present invention.
Fig. 13 is a schematic cross-sectional diagram showing one example of a process chart of a method for producing a multilayer resin sheet according to the present invention.
Fig. 14 is a schematic cross-sectional diagram showing one example of a process chart of a method for producing a multilayer resin sheet according to the present invention.
Fig. 15 is a schematic cross-sectional diagram showing one example of a configuration of a multilayer resin sheet according to the present invention.
Fig. 16 is a schematic cross-sectional diagram showing one example of a configuration of a multilayer resin sheet according to the present invention.
Fig. 17 is a schematic cross-sectional diagram showing one example of a process chart of a method for producing a resin sheet laminate according to the present invention.
Fig. 18 is a diagram showing one example of particle size distribution of a filler embedded in a resin layer of a multilayer resin sheet according to the present invention.
Fig. 19 is a diagram showing one example of particle size distribution of a filler embedded in the resin layer of a multilayer resin sheet according to the present invention.

### BEST MODE FOR CARRYING OUT THE INVENTION

In the present description, the term "step" includes not only an independent step but also a step that is not clearly distinguishable from other steps, as long as the effect of the step is achieved. Moreover, in the present description, a numeral value range described with the term "to" refers to a range that includes values described before and after the "to" as a minimum value and a maximum value, respectively. Furthermore, in a case in which there are two or more substances that correspond to a single component, the amount of the component in the composition refers to the total amount of the two or more substances, unless otherwise noted.

### <Multilayer Resin Sheet>

The multilayer resin sheet of the present invention includes a resin layer that includes an epoxy resin monomer, a curing agent and a filler, and an adhesive layer positioned on at least one face of the resin layer. The filler has peaks in ranges of from 0.01 µm to less than 1 µm, from 1 µm to less than 10 µm, and from 10 µm to 100 µm, respectively, in terms of particle size distribution as measured by laser diffractometry. The filler having a particle size of from 10 µm to 100 µm includes a boron nitride filler.

It is also preferred that the multilayer resin sheet of the present invention includes a resin layer that includes an epoxy resin monomer, a curing agent, a first filler having a volume average particle size of from 0.01 µm to less than 1 µm, a second filler having a volume average particle size of from 1 µm to less than 10 µm, and a third filler having a volume average particle size of from 10 µm to 100 µm and including a boron nitride filler; and an adhesive layer positioned on at least one face of the resin layer.

The multilayer resin sheet having a configuration as described above exhibits excellent preservation stability before being cured, and, after being bonded to an adherend by thermocompression, the multilayer resin sheet can achieve a high thermal conductivity and exhibits excellent adhesive strength and an insulation property (dielectric breakdown strength). The following is a presumptive reason for the above achievements, for example.

By positioning an adhesive layer on a resin layer to form a multilayer resin sheet, the adhesive strength of the sheet can be increased. This is because it is possible to form the adhesive layer with a resin that has a high adhesive strength and, in addition, a low elastic modulus that enables absorption of a linear expansion difference with respect to the adherend.

For the purpose of improving the adhesive strength of a thermally conductive adhesive sheet, there is also a technique of imparting the thermally conductive resin layer with adhesion and thermal conductivity by using a resin that is highly adhesive for the resin layer. In this case, it is essential to increase the amount of a filler in order to achieve a high thermal conductivity. However, if the amount of a filler is increased, there is a possibility that the melt viscosity of the resin layer is increased or the resin sheet becomes rigid and brittle. Therefore, thermal conductivity and adhesive strength are properties that contradict each other.

In a case in which an adhesive layer that does not include a filler is simply provided on the resin layer, thermal conductivity of the adhesive layer is significantly smaller than that of the resin layer that includes a filler. Therefore, there is a possibility that the adhesive layer may insulate heat, and thermal conductivity in a thickness direction of the entire multilayer resin sheet after being cured may drastically decrease. It is possible to improve thermal conductivity by reducing the thickness of the adhesive layer with respect to the thickness of the resin layer. However, there is a physical limit to reduce the thickness of the adhesive layer, and it is difficult to configure a multilayer resin sheet having excellent thermal conductivity by way of reducing the thickness of the adhesive layer.

In view of the above, the present inventors have arrived at the multilayer resin sheet having a configuration as described above. In a case in which a resin sheet laminate is obtained by bonding the multilayer resin sheet to an adherend by carrying out a heating-and-pressing treatment, the filler in the resin layer moves toward the adhesive layer in a thickness direction of the multilayer resin sheet, whereby at least a part of the third filler particles can be embedded in the adhesive layer, and the filler particles can be moved to a position near the surface of the multilayer resin sheet. As a result, a laminate that exhibits a high thermal conductivity while maintaining sufficient adhesion with respect to the adherend can be obtained. The reason for this considered by the present inventors is as follows. Since the multilayer resin sheet has an adhesive layer on the outermost surface, the multilayer resin sheet exhibits adhesion that is equivalent to a case in which the adhesive layer alone is attached. Moreover, since a part of the third filler in the resin layer is embedded in the adhesive layer by carrying out a heating-and-pressing treatment, the filler moves to a position near the outermost surface of the multilayer resin sheet. Therefore, the multilayer resin sheet exhibits thermal conductivity that is equivalent to a case in which a thermally conductive resin layer alone is attached. Furthermore, when the third filler that is to be embedded in the adhesive layer is boron nitride, which can deform in accordance with the surface of the adherend, excellent thermal conductivity can be achieved at an interface between the adhesive layer and the adherend. Accordingly, it is possible to sufficiently achieve the effects of the invention including thermal conductivity, insulation properties and adhesion.

In order to allow the third filler in the resin layer to be embedded in the adhesive layer, it is preferred to adjust the particle size of the third filler to be from 10 µm to 100 µm, and adjust the content of the total filler to be from 30% by volume to 85% by volume in the total solid content volume of the resin layer. The total solid content volume of the resin layer refers to a total volume of non-volatile components of the resin layer.

Furthermore, in the multilayer resin sheet, a resin composition contained in the resin layer and a resin composition contained in the adhesive layer are preferably in a semicured state. When the multilayer resin sheet is in a semicured state (B-stage state), adhesion with respect to an adherend and handleability of the sheet are improved.
The semicured state (B-stage state) refers to a state in which the resin layer has a viscosity of from 10⁵ Pa·s to 10⁷ Pa·s at room temperature (25°C) and a resin component is softened to exhibit tackiness as the resin layer is heated to a temperature of from 100°C to 180°C, and as the heating continues, curing reaction proceeds and the viscosity increases to 10⁷ Pa·s or more, thereby exhibiting adhesion. The viscosity can be measured by dynamic viscoelastic measurement (frequency: 1 Hz, load: 40 g, temperature increase rate: 5°C/min).

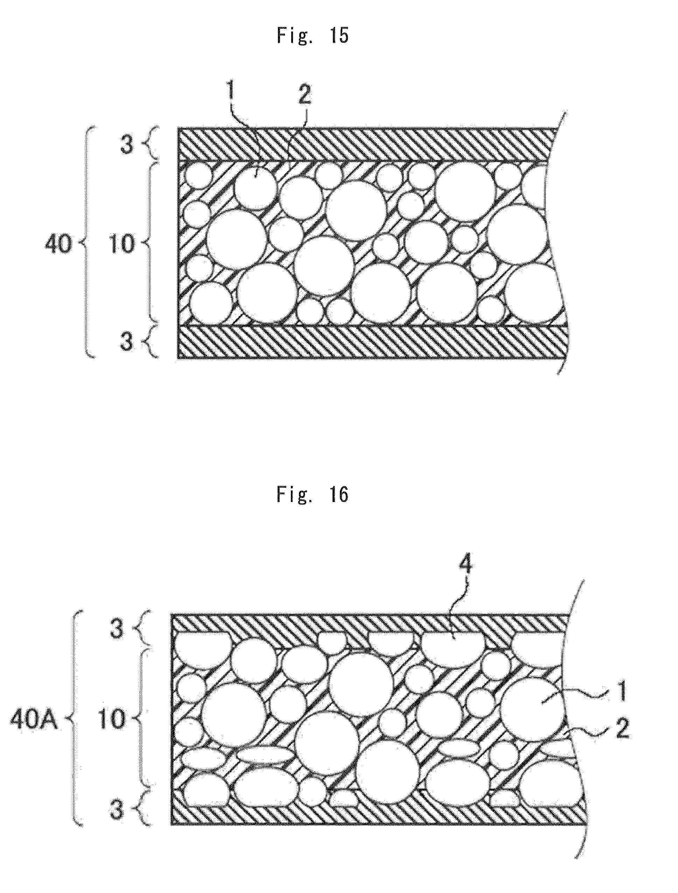

An example of the configuration of the multilayer resin sheet will be described with reference to drawings. Multilayer resin sheet 40, shown in the schematic cross-sectional diagram of Fig. 15, has adhesive layers 3 that are positioned on both faces of a resin layer that includes filler 1 and resin composition 2. Filler 1 is not embedded in the adhesive layer before the multilayer resin sheet is attached to an adherend. In multilayer resin sheet 40A, shown in a schematic cross-sectional diagram of Fig. 16, adhesive layers 3 are positioned on both faces of a resin layer that includes filler 1 and resin composition 2, and there is filler 4 that is embedded in adhesive layer 3. The multilayer resin sheet having a configuration as shown in Fig. 16 exhibits even more improved thermal conductivity while maintaining sufficient adhesion. The reason for this considered by the present inventors is as follows. In a case in which the third filler is embedded in the adhesive layer before the multilayer resin sheet is attached to an adherend, it is easier for the filler in the resin layer to move toward the outermost surface of the multilayer resin sheet. Therefore, the multilayer resin sheet preferably has a configuration of Fig. 15 or Fig. 16, more preferably a configuration of Fig. 16.

### [Resin Layer]

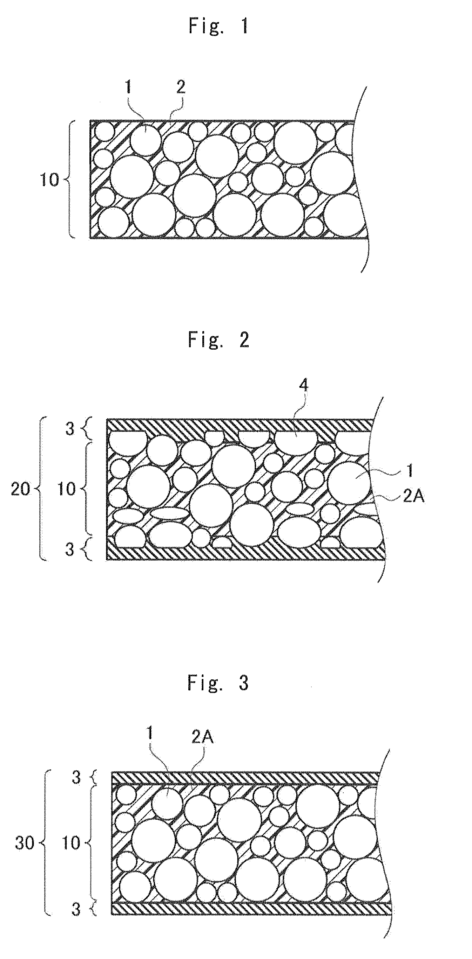

As shown in one example of a schematic cross-sectional diagram of Fig. 1, resin layer 10 in the present invention includes filler 1 that includes first, second and third fillers, and resin composition 2 that includes an epoxy resin monomer, a curing agent and the like.

### (Filler)

Preferably, the resin layer includes at least three kinds of fillers having different volume average particle sizes. Among the fillers, the first filler has a volume average particle size of from 0.01 µm to less than 1 µm, preferably from 0.05 µm to 0.8 µm from the viewpoint of dispersibility, more preferably from 0.1 µm to 0.6 µm from the viewpoint of filling efficiency. The second filler has a volume average particle size of from 1 µm to less than 10 µm, preferably from 2 µm to 8 µm from the viewpoint of resin melt viscosity, more preferably from 2 µm to 6 µm from the viewpoint of filling efficiency. The third filler has a volume average particle size of from 10 µm to 100 µm, preferably from 15 µm to 60 µm from the viewpoint of an insulation property, more preferably from 20 µm to 50 µm from the viewpoint of thermal conductivity. By including three kinds of fillers having different volume average particle sizes, thermal conductivity can be effectively improved.

When the particle size distribution of the whole filler having the configuration as described above is measured, peaks are shown in ranges of from 0.01 µm to less than 1 µm, from 1 µm to less than 10 µm, and 10 µm to 100 µm, respectively, with a particle size on the abscissa and a frequency on the ordinate.

The volume average particle size of the filler in the present invention can be obtained by actual measurement with laser diffractometry or cross-sectional observation of the resin layer. In a case of laser diffractometry, measurement can be performed by extracting the filler in the resin composition and measuring the same with a laser diffraction/scattering particle size distribution analyzer (for example, LS230, manufactured by Beckman Coulter, Inc.) Specifically, a filler component is extracted from the resin composition with an organic solvent, nitric acid, aqua regia or the like, and the component is sufficiently dispersed with an ultrasonic dispersing machine or the like. By measuring the particle size distribution of the dispersion, the volume average particle size of the filler can be quantitatively determined.

Alternatively, the measurement can be performed by observing a cross-section of the resin layer, the multilayer resin sheet or a cured material thereof, with a scanning electron microscope. Specifically, the resin layer is embedded in a transparent epoxy resin, and the epoxy resin is polished with a polisher or a slurry to expose a cross-section of the resin layer. By directly observing the cross-section of the resin layer, the particles size of the filler can be quantitatively determined. It is desirable to conduct a three-dimensional structural analysis by carrying out two-dimensional cross-sectional observation in a continuous manner with an FIB system (focused ion beam SEM) or the like.

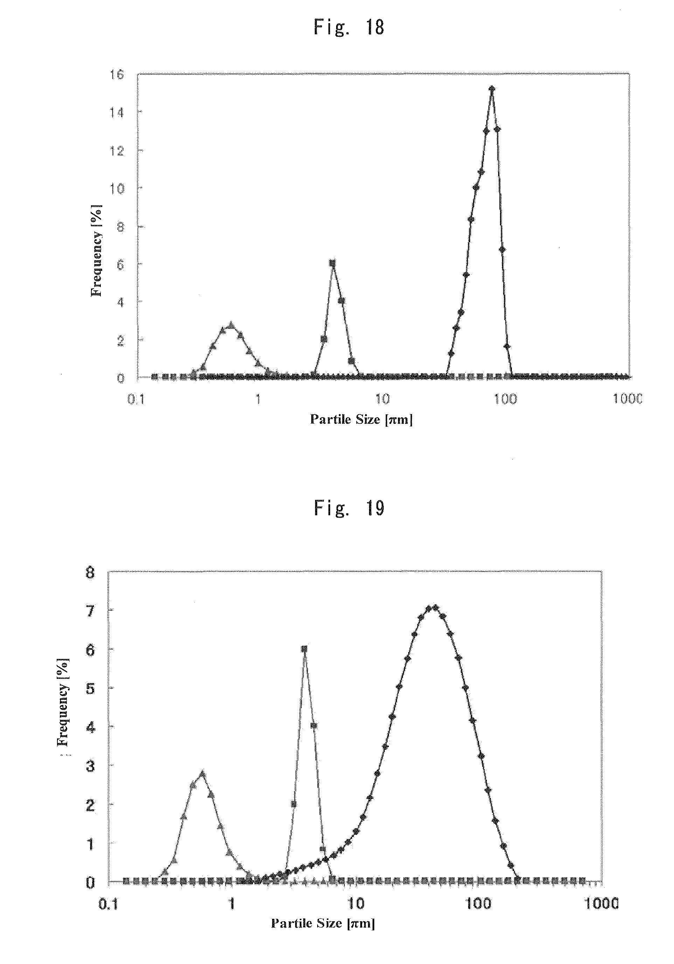

Fig. 18 and Fig. 19 show examples of the particle size distribution of the filler included in the resin layer of the multilayer resin sheet. As shown in Fig. 18 and Fig. 19, peaks of the particle size distribution exist in ranges of a particle size of from 0.01 µm to less than 1 µm, a particle size of from 1 µm to less than 10 µm, and a particle size of 10 µm to 100 µm, respectively. By using the resin layer including the filler having a particle size distribution as described above, the multilayer resin sheet can sufficiently exhibit functions such as thermal conductivity and an insulation property.

The first filler, the second filler and the third filler in the present invention have the volume average particle sizes as described above, respectively. From the viewpoint of thermal conductivity and an insulation property, the ratio of the volume average particle size of the second filler to the volume average particle size of the first filler (volume average particle size of second filler / volume average particle size of first filler) is preferably from 5 to 50, more preferably from 8 to 20 from the viewpoint of filling efficiency and thermal conductivity.
From the viewpoint of thermal conductivity and an insulation property, the ratio of the volume average particle size of the third filler to the volume average particle size of the second filler (volume average particle size of third filler / volume average particle size of third filler) is preferably from 3 to 40, more preferably from 5 to 30.

In the present invention, the particle size distributions of the first filler, the second filler and the third filler are not specifically restricted and may be broad or narrow, as long as the fillers have the volume average particle sizes as specified above.

Moreover, the filler in the present invention preferably includes the first filler, the second filler and the third filler as the entire filler. Namely, in the measurement of the particle size distribution of the entire filler, the filler preferably exhibits at least three peaks including a peak corresponding to the first filler having a volume average particle size of from 0.01 µm to less than 1 µm, a peak corresponding to the second filler having a volume average particle size of from 1 µm to less than 10 µm, and a peak corresponding to the third filler having a volume average particle size of from 10 µm to 100 µm.

The filler as described above can be obtained by mixing the first filler, the second filler and the third filler each having a single peak in the particle size distribution, or can be formed from a filler having two or more peaks in the particle size distribution.

In the present invention, the content by volume of each filler in the total filler is preferably from 1% to 15% for the first filler, from 10% to 40% for the second filler, and from 45% to 80% for the third filler. From the viewpoint of filling efficiency and thermal conductivity, the content by volume of each filler in the total filler is more preferably from 6% to 15% for the first filler, from 18% to 35% for the second filler, and from 50% to 70% for the third filler. By satisfying the ranges as described above, it is possible to suppress deterioration in formability due to viscosity increase and deterioration in an insulation property due to generation of voids.
In addition, by increasing the content of the third filler as much as possible, and subsequently increasing the content of the second filler, thermal conductivity can be improved more effectively. As such, thermal conductivity can be improved more effectively by including at least three fillers having different volume average particle sizes at contents (by volume) as specified above.

The first filler and the second filler are not specifically restricted as long as they are inorganic compounds having insulation properties, but are preferably inorganic materials with a high thermal conductivity.
Specific examples of the first filler and the second filler include aluminum oxide, magnesium oxide, boron nitride, aluminum nitride, silicon nitride, talc, mica, aluminum hydroxide and barium sulfate. Among these, aluminum oxide, boron nitride and aluminum nitride are preferable from the viewpoint of thermal conductivity. A single material or a combination of two or more may be used as the filler.

The third filler at least includes boron nitride, and may further include an insulating inorganic compound in addition to boron nitride. By including boron nitride, thermal conductivity is remarkably increased. The reason for this is considered to be as follows, for example. The Mohs hardness of boron nitride is 2, which is lower as compared with other insulating ceramics such as alumina and aluminum nitride (for example, hardness of 8), and thus boron nitride is softer than other insulating ceramics. Further, boron nitride having a globular or rounded shape forms a cavity aggregation of primary particles, which is harder than a molten resin but is easy to deform. Therefore, the third filler including boron nitride particles can be easily deformed by applying an external force in a thermocompression step, a laminate step, or a pressing step, which are described later. During deformation, resin is excluded from spaces among the filler particles. Accordingly, it becomes easier to form a structure in which the third filler including boron nitride exists in a continuous manner inside the resin layer, whereby thermal conductivity is significantly improved.

The particle shape of the filler is not specifically limited, and examples include a globular shape, a rounded shape, a fracture shape, a scale shape, and an aggregation particle shape. The globular shape and the rounded shape are preferable from the viewpoint of filling efficiency and thermal conductivity.

The filler in the present invention preferably has a volume average particle size for the first filler of from 0.01 µm to less than 1 µm, a volume average particle size for the second filler of from 1 µm to less than 10 µm, and a volume average particle size for the third filler of from 10 µm to 100 µm. More preferably, the contents by volume of the first filler, the second filler and the third filler are from 1% to 15%, from 10% to 40%, and from 45% to 80%, respectively. Furthermore, the filler preferably has a volume average particle size for the first filler of from 0.01 µm to 0.6 µm, a volume average particle size for the second filler of from 2 µm to 6 µm, and a volume average particle size for the third filler of from 20 µm to 50 µm. More preferably, the contents by volume of the first filler, the second filler and the third filler are from 6% to 15%, from 18% to 35%, and from 50% to 70%, respectively.

In the present invention, the total content of the filler in the resin layer is not specifically limited. From the viewpoint of thermal conductivity and adhesion, it is preferably from 30% by volume to 85% by volume in a total solid content of the resin layer, more preferably from 50% by volume to 80% by volume from the viewpoint of thermal conductivity.
The total solid content of the resin layer refers to a total amount of non-volatile components among components of the resin layer.

### (Epoxy Resin Monomer)

The resin layer in the present invention includes at least one epoxy resin monomer (hereinafter, also referred to as an "epoxy resin"). The epoxy resin is not specifically restricted and may be an epoxy resin that is commonly used. Preferably, the epoxy resin exhibits a low viscosity prior to curing, i.e., excellent filler filling efficiency and formability, and exhibits a high thermal conductivity after thermally curing, in addition to a high heat resistance and a high adhesion.

Typical examples of the epoxy resin include bisphenol A glycidyl ether, bisphenol F glycidyl ether, bisphenol S glycidyl ether, bisphenol AD glycidyl ether, hydrogenated bisphenol A glycidyl ether, phenol novolac glycidyl ether, cresol novolac glycidyl ether, bisphenol A novolac glycidyl ether, naphthalene glycidyl ether, biphenol glycidyl ether, and dihydroxypentadiene glycidyl ether.

Among these epoxy resins, a polyfunctional epoxy resin is preferable from the viewpoint of forming a cured resin with a high Tg (glass transition temperature) and a high thermal conductivity. Examples of the polyfunctional epoxy resin include an epoxy resin obtained by epoxidation of phenol novolac such as phenol novolac epoxy resin, cresol novolac epoxy resin and triphenol epoxy resin. An epoxy resin having a mesogenic group also exhibits a high thermal conductivity.

The epoxy resin in the present invention may include a liquid epoxy resin. By including a liquid epoxy resin, it is possible to lower the resin softening point of a sheet at A-stage or B-stage. More specifically, handleability of the sheet may improve in some cases. However, since there are liquid epoxy resins having a low Tg or a low thermal conductivity, the content of the liquid epoxy resin may be appropriately selected in view of the properties of the cured resin.

From the viewpoint of thermal conductivity, the epoxy resin monomer is preferably at least one of an epoxy resin having a mesogenic group and a triphenol novolac epoxy resin.

The mesogenic group is not specifically limited as long as it enables formation of a higher-order structure derived from the mesogenic group in a cured resin that is formed from the epoxy resin monomer and a curing agent.
The higher-order structure refers to a structure in which molecules are orientationally positioned in a resin composition after curing, for example, a crystalline structure or a liquid crystal structure that exists in the cured resin. The existence of a crystalline structure or a liquid crystal structure can be confirmed in a direct manner by, for example, observation with a polarization microscope under crossed Nichol or X-ray scattering. It is also possible to confirm the existence in an indirect manner from a decrease in a change of a storage elastic modulus with respect to temperature.

Specific examples of the mesogenic group include a biphenyl group, a terphenyl group, a terphenyl analog, an anthracene group, and a group in which mesogenic groups as described are connected via an azomethine group or an ester group.

In the present invention, a high thermal conductivity can be achieved by forming a cured resin from an epoxy resin monomer having a mesogenic group with a curing agent. The reason for this is considered to be as follows, for example. By forming a cured resin from an epoxy resin monomer having a mesogenic group together with a curing agent (preferably, novolac resin as described below), a higher-order structure with a high regularity that is derived from the mesogenic group can be formed in the cured resin. Therefore, it is possible to suppress scattering of phonon, which is a medium for thermal conduction in an insulating resin, thereby achieving a high thermal conductivity.

Specific examples of the epoxy resin monomer having a mesogenic group include 4,4'-biphenol glycidyl ether, 1-{(-methyl-4-oxiranylmethoxy)phenyl}-4-(4-oxiranylmethoxyphenyl)-1-cyclohexene, 4-(oxiranylmethoxy)benzoic acid-1,8-octanediylbis(oxy-1,4-phenylene)ester, and 2,6-bis[4-[4-[2-(oxiranylmethoxy)ethoxy]phenyl]phenoxy]pyridine. From the viewpoint of improving thermal conductivity, 1-{(3-methyl-4-oxiranylmethoxy)phenyl}-4-(4-oxiranylmethoxyphenyl)-1-cyclexene is especially preferable.

The content of the epoxy resin monomer in the resin layer is not specifically limited. From the viewpoint of thermal conductivity and adhesion, it is preferably from 3 mass% to 30 mass% in a total solid content of the resin layer. From the viewpoint of thermal conductivity, it is more preferably from 5 mass% to 25 mass%.

### (Curing Agent)

The resin layer in the present invention includes at least one curing agent. The curing agent is not specifically limited as long as it is a compound that can react with an epoxy resin monomer to form a cured resin. Specific examples of the curing agent include polyaddition-type curing agents such as novolac resins, aromatic amine curing agents, aliphatic amine curing agents, mercaptan curing agents and anhydride curing agents, and latent curing agents such as imidazole and TPP.
From the viewpoint of thermal conductivity and an insulation property, the curing agent preferably includes at least one novolac resin.

The novolac resin is not specifically limited as long as it is a novolac resin usually used as a curing agent for an epoxy resin. From the viewpoint of thermal conductivity and an insulation property, the curing agent preferably includes at least one compound having a structural unit represented by the following formula (I).

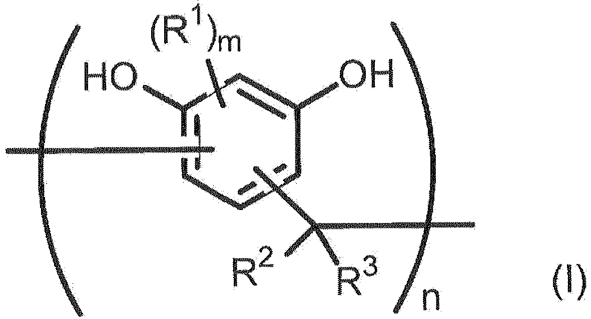

In formula (I), R¹ represents an alkyl group, an aryl group or an aralkyl group. The alkyl group, aryl group or aralkyl group represented by R¹ may further include a substituent group when possible. Examples of the substituent group include an alkyl group, an aryl group, a halogen atom and a hydroxy group. The m represents an integer of 0 to 2, and if m is 2, the two of R¹ may be the same or different from each other. In the present invention, m is preferably 0 or 1, more preferably 0.

The novolac resin preferably includes at least one compound having a structural unit represented by formula (I), but may include two or more compounds each having a structural unit represented by formula (I).

The novolac resin preferably includes a partial structure derived from resorcinol as a phenol compound, but may further include one or more partial structures derived from a phenol compound other than resorcinol. Examples of the phenol compound other than resorcinol include phenol, cresol, catechol and hydroquinone. The novolac resin may include only one kind of partial structure derived from a phenol compound, or may include two or more kinds in combination.
The partial structure derived from a phenol compound refers to a monovalent or divalent group having a structure in which one or two hydrogen atoms are removed from a benzene ring of a phenol compound. The position from which a hydrogen atom is removed is not specifically limited.

In the present invention, from the viewpoint of thermal conductivity and adhesion, the partial structure derived from a phenol compound other than resorcinol is preferably a partial structure derived from at least one selected from phenol, cresol, catechol, hydroquinone, 1,2,3-trihydroxybenzene, 1,2,4-trihydroxybenzene and 1,3,5-trihydroxybenzene; more preferably a partial structure derived from at least one selected from catechol and hydroquinone; further preferably a catechol resorcinol novolac resin or a hydroquinone resorcinol novolac resin.

The content of the partial structure derived from resorcinol in the novolac resin is not specifically limited. From the viewpoint of thermal conductivity, the content of the partial structure derived from resorcinol with respect to a total mass of the novolac resin is preferably 55 mass% or more, more preferably 80 mass% or more from the viewpoint of achieving even higher thermal conductivity.

In formula (I), each of R² and R³ independently represents a hydrogen atom, an alkyl group, an aryl group, a phenyl group or an aralkyl group. The alkyl group, phenyl group, aryl group and aralkyl group represented by R² and R³ may further include a substituent group when possible. Examples of the substituent group include an alkyl group, an aryl group, a halogen atom and a hydroxy group.

The number average molecular weight of the novolac resin is preferably 800 or less from the viewpoint of thermal conductivity, more preferably from 300 to 700 from the viewpoint of resin viscosity, thermal conductivity and a glass transition temperature, yet more preferably from 350 to 550 from the viewpoint of even higher thermal conductivity.

In the resin layer of the present invention, the novolac resin that includes a compound having a structural unit represented by formula (I) may include a monomer that is a phenol compound that forms the novolac resin. The content of the monomer that is a phenol compound that forms the novolac resin (hereinafter, also referred to as a "monomer content") is not specifically limited, and the monomer content is preferably from 5 mass% to 80 mass% in the novolac resin from the viewpoint of formability, thermal conductivity and a glass transition temperature, more preferably from 15 mass% to 60 mass% from the viewpoint of a high thermal conductivity and a glass transition temperature, further preferably from 20 mass% to 50 mass% from the viewpoint of even higher thermal conductivity and a glass transition temperature.

When the monomer content is 20 mass% or more, an increase in the viscosity of the novolac resin is suppressed, and adhesion of the filler is improved. When the monomer content ratio is 50 mass% or less, the density of a higher-order structure is increased due to a cross-linking reaction during curing, thereby achieving excellent thermal conductivity and heat resistance.

Examples of the monomer of a phenol compound that forms the novolac resin include resorcinol, catechol and hydroquinone, and the monomer preferably includes at least resorcinol.

The content of the curing agent in the resin layer is not specifically limited. From the viewpoint of thermal conductivity and adhesion , the content of the curing agent in the resin layer is preferably from 1 mass% to 10 mass% in a total solid content of the resin layer, more preferably from 1 mass% to 8 mass%.
The content of the curing agent based on equivalent in the resin layer is preferably from 0.8 to 1.2 with respect to the epoxy resin monomer, more preferably from 0.9 to 1.1.

### (Silane Coupling Agent)

The resin layer in the present invention may further include at least one silane coupling agent. By including a silane coupling agent, bonding between the filler and the resin component including an epoxy resin and a novolac resin can be improved, a higher thermal conductivity and a stronger adhesion can be achieved.

The silane coupling agent is not specifically limited as long as it is a compound having a functional group that is to be bound to the resin component and a functional group that is to be bound to the filler, and a common silane coupling agent may be used. Examples of the functional group that is to be bound to the filler include a trialkoxysilyl group such as a trimethoxysilyl group and a triethoxysilyl group. Examples of the functional group that is to be bound to the resin component include an epoxy group, an amino group, a mercapto group, an ureido group and an aminophenyl group.

Specific examples of the silane coupling agent include 3-glycidoxypropyltrimethoxysilane, 3-glycidoxypropyltriethoxysilane, 3-glycidoxypropylmethyldimethoxysilane, 2-(3,4-epoxycyclohexyl)ethyltrimethoxysilane, 3-aminopropyltriethoxysilane, 3-(2-aminoethyl)aminopropyltriethoxysilane, 3-aminopropyltrimethoxysilane, 3-(2-aminoethyl)aminopropyltrimethoxysilane, 3 -phenylaminopropyltrimethoxysilane, 3-mercaptotriethoxysilane and 3-ureidopropyltriethoxysilane.
A silane coupling agent oligomer, typified by SC-6000KS2 (manufactured by Hitachi Chemical Coated Sand Co., Ltd.) can also be used.
A single kind of silane coupling agent may be used alone, or two or more kinds may be used in combination.

The content of the silane coupling agent in the resin layer is not specifically limited. From the viewpoint of thermal conductivity, the content of the silane coupling agent in the resin layer is from 0.02 mass% to 0.83 mass% with respect to a total solid content of the resin layer, more preferably 0.04 mass% to 0.42 mass%.
The content of the silane coupling agent with respect to the filler is preferably from 0.02 mass% to 1 mass% from the viewpoint of thermal conductivity, an insulation property and formability, more preferably from 0.05 mass% to 0.5 mass% from the viewpoint of a high thermal conductivity.

### (Other Components)

The resin layer of the present invention may include other components in addition to the essential components as described above, as needed. Examples of the other components include an organic solvent, a curing accelerator, a dispersing agent and the like.

### (Method for Preparing Resin Layer)

The method for preparing the resin layer of the present invention may be a common method for producing a resin sheet without specific limitation. For example, the resin layer may be prepared by preparing a resin composition by mixing the epoxy resin monomer, the curing agent (preferably, novolac resin), the filler and other components as needed, with an organic solvent; forming the resin composition into a sheet shape; and removing at least a part of the organic solvent (drying).

The resin layer of the present invention is preferably obtained by removing (drying) at least a part of an organic solvent from a resin composition layer in a sheet form that is formed from the resin composition containing an organic solvent. Moreover, the resin layer is preferably made into a semicured state (B-stage) by subjecting the resin layer from which at least a part of an organic solvent has been removed to a thermocompression treatment.

The organic solvent is not specifically restricted and may be selected depending on purposes. The organic solvent is to be removed during a drying step while preparing the resin layer, and if a large amount of the organic solvent remains, it may affect thermal conductivity or insulation properties. Therefore, the organic solvent preferably has a low boiling point or a low vapor pressure. It is also necessary to select a suitable organic solvent in view of the method or conditions for drying, since if the organic solvent is completely removed during drying, the resin layer may be hardened and adhesiveness may be lost.
The organic solvent may be appropriately selected based on the type of the resin or the filler, the conditions for drying during preparation of the resin layer, and the like.

Specifically, for example, alcohols such as methanol, ethanol, 1-propanol, 2-propanol, 1-butanol, 2-propanol and cyclohexanol; ketone solvents such as methylethylketone, cyclohexanone and cyclopentanone; and nitrogen-containing solvents such as dimethylformamide and dimethylacetamide may be preferably used.

The mixing and dispersing of the components of the resin composition may be performed by appropriately combining common dispersing machines such as a mixing machine, a stone mill machine, a triple roll mill, and a ball mill.

The resin layer in the present invention may be prepared by applying the resin composition that includes the filler onto a support to form a coating layer, and removing (drying) at least a part of the organic solvent from the coating layer to form the resin composition into a sheet shape. The resin layer in a sheet shape may be provided with a support on one or both sides in order to protect the adhesive surface. By providing a support, the resin composition may be protected from adhesion of foreign matter to the adhesive surface or an impact from the external environment.
The thickness of the resin layer in the present invention may be appropriately selected depending on purposes, and the thickness may be, for example, from 50 µm to 400 µm, preferably from 100 µm to 250 µm.

Examples of the support include a plastic film such as a polytetrafluoroethylene film, a polyethylene terephthalate film, a polyethylene film, a polypropylene film, a polymethylpentene film and a polyimide film. The film may be subjected to a surface treatment such as primer coating, UV treatment, corona discharge treatment, polishing treatment, etching treatment or release treatment, as needed. In addition, metal such as a copper foil or an aluminum plate may be used as the support.

In a case in which the support is a film, the thickness thereof is not specifically limited and determined as appropriate according to the thickness of the resin layer to be formed or the intended use of the multilayer resin sheet, based on the knowledge of those skilled in the art. From the viewpoint of economic efficiency and handleability, the thickness of the film is preferably from 10 µm to 150 µm, more preferably from 30 µm to 110 µm.

The methods of applying and drying the resin composition are not specifically restricted and may be appropriately selected from ordinary methods. Examples of the application method include a Comma Coater, a die coater and dip coating. Examples of the drying method include heat drying under ordinary or reduced pressure, natural drying and freeze drying.

The resin layer may be a single coating layer formed on the support, or another coating layer may be formed thereon. Alternatively, the resin layer may be formed by laminating two or more coating layers that have been formed on a support.

Moreover, in the resin layer of the present invention, the resin composition is preferably in a semicured state. When the resin layer in a semicured state (B-stage state), handleability is improved.
The method for obtaining the resin layer that is in a semicured state is not specifically limited, and examples include performing a thermocompression treatment with a hot pressing machine or a laminator. The conditions for thermocompression may be appropriately selected based on the configuration of the resin composition. For example, the heating and pressurizing may be performed at a heating temperature of from 80°C to 180°C and a pressure of from 0.1 MPa to 100 MPa for from 0.3 minutes to 30 minutes.

### [Adhesive Layer]

The multilayer resin sheet of the present invention includes an adhesive layer on at least one face of the resin layer. The resin for forming the adhesive layer is not specifically restricted as long as it exhibits adhesion, but an insulating resin is preferred. From the viewpoint of adhesion, insulating properties and heat resistance, the resin preferably includes at least one of a polyimide resin, a polyamide-imide resin, a modified polyamide-imide resin and an epoxy resin. The resin may be used alone or two or more kinds may be used in combination. From the viewpoint of adhesion, the resin is preferably at least one selected from the group consisting of a polyimide resin, a modified polyamide-imide resin and an epoxy resin.

Examples of the polyimide resin include products typified by UPICOAT FS-100L (manufactured by Ube Industries, Ltd.), SEMICOFINE SP-300, SP-400, SP-800 (manufactured by Toray Industries, Inc.), and U IMIDE series (manufactured by Unitika Ltd.) Examples of the polyamide-imide resin and the modified polyamide-imide resin include VYLOMAX series (manufactured by Toyobo Co., Ltd.) and TORLON (manufactured by Solvay Advanced Polymers K.K.) From the viewpoint of a high heat resistance and a high adhesion, a modified polyamide-imide resin typified by KS series (manufactured by Hitachi Chemical Co., Ltd.) is preferable.

A polyimide resin, a polyamide-imide resin and a modified polyamide-imide resin, which are suitable for the adhesive layer, may be used alone or as a combination of two or more kinds. These resins are generally available as a varnish in which the resin is dissolved in a solvent. The adhesive layer may be formed by directly applying the varnish onto a support such as a PET film and drying to remove the solvent to form a film.

It is also possible to use an epoxy resin, which is a typical thermosetting adhesive resin. Specifically, an epoxy resin composition containing an epoxy resin, a curing agent, glycidyl acrylate and a curing accelerator may be used to form the adhesive layer. Details of the epoxy resin composition are described in, for example, JP-A No. 2002-134531, JP-A No. 2002-226796 and JP-A No. 2003-221573.

The epoxy resin used in the adhesive layer in the present invention is not specifically limited, as long as it exhibits adhesion when cured. In particular, a bisphenol A liquid resin or a bisphenol F liquid resin having a molecular weight of 500 or less is preferred in terms of improving fluidity during laminating. It is also possible to add a polyfunctional epoxy resin in order to increase the Tg (glass-transition temperature). Examples of the polyfunctional epoxy resin include a phenol novolac epoxy resin and a cresol novolac epoxy resin.

The curing agent for the epoxy resin may be appropriately selected from generally used curing agents for an epoxy resin. Examples of the curing agent include a polyamide, an anhydride, a phenol novolac, a polysulfide, borontrifluoride, and a compound having two or more phenolic hydroxy groups in one molecule such as bisphenol A, bisphenol F and bisphenol S. In particular, a phenol resin such as a phenol novolac resin, a bisphenol novolac resin or a cresol novolac resin is preferred in view of exhibiting excellent resistance against electric corrosion in a case in which moisture is absorbed.

A curing accelerator is preferably used together with the curing agent, and imidazole compounds are preferred as the curing accelerator. Examples of the imidazole include 2-methylimidazole, 2-ethyl-4-methylimidazole, 1-cyanoethyl-2-phenylimidazole and 1-cyanoethyl-2-phenylimidazolium trimellitate. Imidazole compounds are commercially available from Shikoku Chemicals Corporation under the trade names of 2E4MZ, 2PZ-CN and 2PZ-CNS.

The epoxy resin used for the adhesive layer is preferably a high-molecular-weight epoxy resin that includes a high-molecular-weight resin having compatibility with an epoxy resin. Examples of the high-molecular-weight resin having compatibility with an epoxy resin include a high-molecular-weight epoxy resin, rubber having a highly polar functional group, and reactive rubber having a highly polar functional group. Examples of the reactive rubber having a highly polar functional group include modified acrylic rubber that is obtained by adding an acrylic rubber with a highly polar functional group such as a carboxyl group.
The "compatibility with an epoxy resin" refers to a property of forming a homogeneous mixture with an epoxy resin without separating from each other into two phases after curing.
The weight-average molecular weight of the high-molecular-weight resin is not specifically limited. From the viewpoint of reducing tackiness of the adhesive layer at B-stage or improving flexibility when cured, the weight-average molecular weight is preferably 30000 or more.

High-molecular-weight epoxy resins having a molecular weight of from 30000 to 80000 and ultrahigh-molecular-weight epoxy resins having a molecular weight of more than 80000 are described in Japanese Published Examined Application Nos. 7-59617, 7-59618, 7-59619, 7-59620, 7-64911 and 7-68327.
With regard to the reactive rubber having a highly polar functional group, an acrylic rubber having a carboxyl group is commercially available from Nagase ChemteX Corporation under the trade name of HTR-860P.

The amount of the high-molecular-weight resin that has compatibility with an epoxy resin and has a weight-average molecular weight of 30000 or more is preferably 10 parts by mass or more, and preferably 40 parts by mass or less, with respect to 100 parts by mass of the resin that forms the adhesive layer. If the amount is 10 parts by mass or more, lack of flexibility of a phase including the epoxy resin as a major component (hereinafter, referred to as an epoxy resin phase), a decrease in tackiness, a decrease in an insulation property due to a crack or the like can be prevented. If the amount is 40 parts by mass or less, a decrease in Tg of the epoxy resin phase can be prevented.

The weight-average molecular weight of the high-molecular-weight epoxy resin is preferably from 20000 to 500000. In this range, a decrease in strength and flexibility as a sheet or a film can be suppressed, and an increase in tackiness can be suppressed.

The adhesive layer may include at least one kind of filler. The filler is not specifically restricted as long as it is an insulating inorganic compound, but is preferably highly thermally conductive. Examples of the filler include aluminum oxide, magnesium oxide, boron nitride, aluminum nitride, silicon nitride, talc, mica, aluminum hydroxide and barium sulfate. In particular, aluminum oxide, boron nitride, and aluminum nitride are preferable from the viewpoint of thermal conductivity. A single filler may be used, or two or more fillers may be used in combination.

The volume average particle size of the filler included in the adhesive layer is not specifically limited. For example, the volume average particle size is preferably from 0.1 µm to 10 µm, more preferably from 0.5 µm to 5 µm, from the viewpoint of thermal conductivity.

In a case in which the adhesive layer is in the form of a film, the content of the filler in the adhesive layer is preferably 50% by volume or less from the viewpoint of a balance between adhesion and thermal conductivity. Furthermore, it is preferably from 20% by volume to 50% by volume from the viewpoint of thermal conductivity.

The multilayer resin sheet of the present invention is characterized in that the adhesive layer is positioned on at least one face of the resin layer. Examples of a method for positioning the adhesive layer include a method in which the adhesive layer that has been formed into a film as described above is attached to the resin layer, and a method in which the adhesive layer is positioned by applying the resin varnish as described above onto the resin layer and drying to remove the solvent.
In the present invention, a method in which the adhesive layer that has been formed into a film is attached to the resin layer is preferable from the viewpoint of workability. The adhesive layer in the form of a film may be, for example, an adhesive layer sheet with a support that is obtained by applying a coating liquid including an adhesive resin onto a support.

The thickness of the adhesive layer is not specifically limited. From the viewpoint of thermal conductivity and adhesion, the thickness is preferably from 3 µm to 16 µm, more preferably from 4 µm to 14 µm.

Examples of a method for providing the adhesive layer on the resin layer using an adhesive layer in the form of a film include a method in which a laminate obtained by positioning the adhesive layer in the form of a film on the resin layer is subjected to a laminate treatment with a hot press machine, a laminator or the like.
The conditions for heating and pressing in the laminate treatment may be appropriately selected based on the configuration of the resin layer and the adhesive layer. For example, the heating and pressing is preferably performed at a heating temperature of from 80°C to 200°C and a pressure of from 0.2 MPa to 20 MPa, under reduced pressure (for example, 30 kPa or less).

The multilayer resin sheet of the present invention may be provided with a support that protects the surface of the adhesive layer on one or both faces. By providing a support, the multilayer resin sheet can be protected from adhesion of a foreign matter to the adhesive surface or receiving an impact from the external environment. In a case in which the multilayer resin sheet has such a configuration, the support is peeled off from the multilayer resin sheet when using the same.
The support may be positioned on the adhesive layer after forming the adhesive layer. Alternatively, in a case in which the adhesive layer is formed by using an adhesive layer sheet having a support, the support of the adhesive layer sheet may be used as a support for the multilayer resin sheet.

### <Method for Producing Multilayer Resin Sheet>

A first method for producing the multilayer resin sheet includes: a step of obtaining a resin layer that includes an epoxy resin monomer, a curing agent, a first filler having a volume average particle size of from 0.01 µm to less than 1 µm, a second filler having a volume average particle size of from 1 µm to less than 10 µm, and a third filler having a volume average particle size of from 10 µm to 100 µm and including boron nitride; and a step of positioning an adhesive layer on at least one face of the resin layer. The method may include other steps as necessary.

The step of obtaining the resin layer is similar to the method for preparing the resin layer as described above. In the multilayer resin sheet obtained by the first production method, at least a part of the third filler particles may or may not be embedded in the adhesive layer. Preferably, at least a part of the third filler particles is embedded in the adhesive layer, from the viewpoint of suppressing flowage of the resin during attachment, and suppressing deformation of an adherend by reducing a pressure applied for attachment.

Examples of a method for providing the adhesive layer on the resin layer include a method in which the resin layer is attached with the adhesive layer that has been formed into a film as described above, and a method in which an adhesive layer is formed by applying a resin varnish on the surface of the resin layer and drying to remove a solvent.
In the present invention, a method in which the resin layer is attached with the adhesive layer that has been formed into a film is preferable from the viewpoint of workability.

Examples of a method for positioning the adhesive layer on the resin layer by using an adhesive layer in the form of a film include a method in which a laminate of the resin layer and the film-shaped adhesive layer is subjected to a thermocompression treatment with, for example, a pressing machine, a laminating machine, a rubber roll pressing machine, a metal roll pressing machine, or a vacuum pressing machine. The conditions for thermocompression during providing the adhesive layer on the resin layer are, for example, preferably a heating temperature of from 60°C to 220°C, a pressure of from 0.1 MPa to 100 MPa, and a treatment time of from 0.1 minutes to 60 minutes. More preferably, the conditions are a temperature of from 80°C to 180°C, a pressure of from 0.2 MPa to 80 MPa, and a treatment time of from 0.15 minutes to 30 minutes.
A step of obtaining the laminate may be performed under atmospheric pressure (ordinary pressure), but is preferably performed under reduced pressure. The reduced pressure condition is preferably 30000 Pa or less, more preferably 10000 Pa or less.

The first production method preferably further includes a step of allowing at least a part of the third filler particles to be embedded in the adhesive layer formed on the resin layer. The multilayer resin sheet obtained through the step has a structure in which at least a part of the third filler particles in the resin layer is embedded in the adhesive layer, prior to being attached to an adherend. Therefore, it is possible to suppress flowage of the resin during attachment, and suppress deformation of the adherend by reducing the pressure applied for the attachment.

Examples of a method for allowing the third filler particles in the resin layer to be embedded in the adhesive layer by performing a thermocompression treatment after forming the adhesive layer on the resin layer include a method of employing a vacuum hot press machine or a metal hot roll.

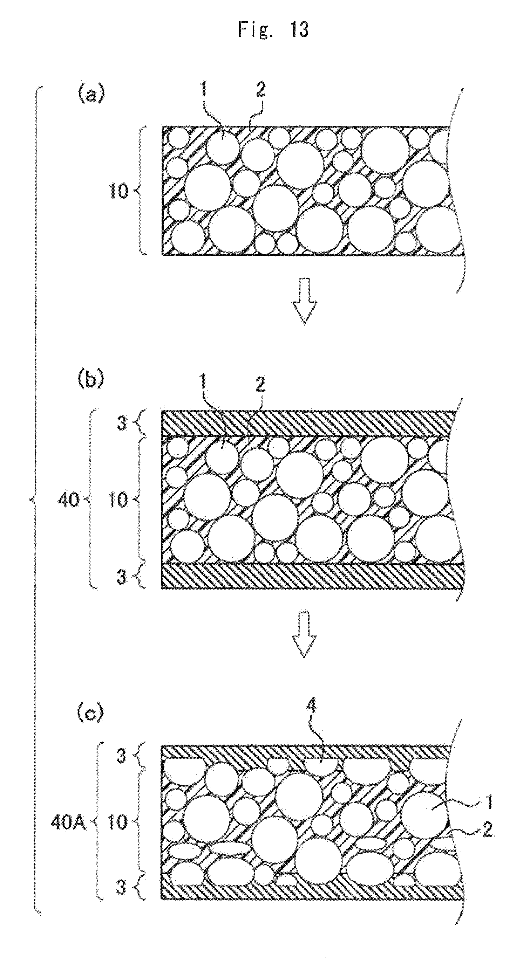

In the following, an example of the first production method including a step of allowing at least a part of the third filler particles in the resin layer to be embedded in the adhesive layer will be described with reference to drawings. In Fig. 13(a), resin layer 10 that includes filler 1 and resin composition 2 is obtained in a manner as described above. Resin composition 2 includes an epoxy resin monomer and a curing agent, and filler 1 includes a first filler having a volume average particle size of from 0.01 µm to less than 1 µm, a second filler having a volume average particle size of from 1 µm to less than 10 µm, and a third filler having a volume average particle size of from 10 µm to 100 µm and including boron nitride. Next, as shown in Fig. 13(b), adhesive layers 3 are positioned on both faces of resin layer 10. The method for forming adhesive layers 3 is as described above. Next, resin sheet 40 having adhesive layers 3 positioned on both faces of resin layer 10 is subjected to a thermocompression treatment with a vacuum hot press machine or a metal hot roll such that a part of the filler in the resin layer 10 is allowed to be embedded in adhesive layers 3. In this way, as shown in Fig. 13(c), multilayer resin sheet 40A in which filler 4 is embedded in adhesive layer 3 can be produced.

A second method for producing the multilayer resin sheet includes: a step of obtaining a resin layer that includes an epoxy resin monomer, a curing agent, a first filler having a volume average particle size of from 0.01 µm to less than 1 µm, a second filler having a volume average particle size of from 1 µm to less than 10 µm, and a third filler having a volume average particle size of from 10 µm to 100 µm and including boron nitride; and a step of positioning an adhesive layer on at least one face of the resin layer and allowing at least a part of the third filler to be embedded in the adhesive layer. The method may include other steps as necessary.

### The step of obtaining the resin layer is as described above.

The step of providing the adhesive layer on the resin layer and allowing at least a part of the third filler to be embedded in the adhesive layer is preferably carried out by adjusting the conditions for a thermocompression treatment for providing the adhesive layer on the resin layer to a heating temperature of from 80°C to 220°C, a pressure of from 1 MPa to 100 MPa, and a treatment time of from 0.1 minutes to 60 minutes, for example. More preferably, the temperature is from 100°C to 200°C, the pressure is from 1.5 MPa to 80 MPa, and the treatment time is from 0.3 minutes to 40 minutes. The conditions are further preferably appropriately determined in consideration of the pressing step as described later.
The thermocompression may be performed under atmospheric pressure (ordinary pressure), but is preferably performed under reduced pressure. The reduced pressure condition is preferably 30000 Pa or less, more preferably 10000 Pa or less.

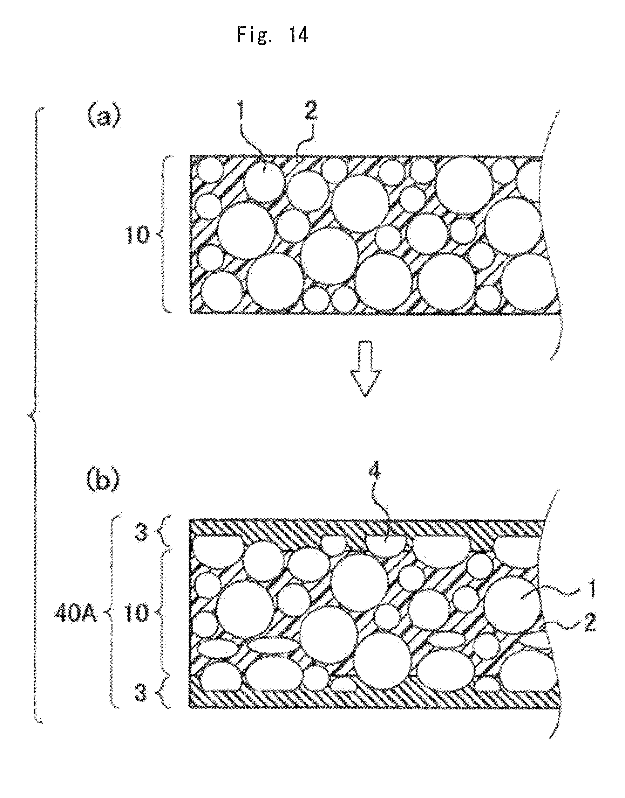

In the following, an example of the second production method will be described with reference to drawings. In Fig. 14(a), resin layer 10 that includes filler 1 and resin composition 2 is obtained in a manner as described above. Resin composition 2 includes an epoxy resin monomer and a curing agent, and filler 1 includes a first filler having a volume average particle size of from 0.01 µm to less than 1 µm, a second filler having a volume average particle size of from 1 µm to less than 10 µm, and a third filler having a volume average particle size of from 10 µm to 100 µm and including boron nitride. Subsequently, adhesive layers 3 are formed on both faces of resin layer 10 and a part of the filler in resin layer 10 is allowed to be embedded in adhesive layers 3 by controlling the conditions for thermocompression during providing the adhesive layer in a manner as described above. In this way, as shown in Fig. 14(b), multilayer resin sheet 40A in which filler 4 is embedded in adhesive layers 3 can be produced.

### <Method for Using Multilayer Resin Sheet>

The multilayer resin sheet of the present invention can be used in a manner as described below. For example, in a case of a multilayer resin sheet having an adhesive layer on one face of a resin layer, a laminate is obtained by positioning the multilayer resin sheet such that the adhesive layer side faces an adherend such as a metal plate, and performing a thermocompression treatment (laminate formation step). At this stage, the multilayer resin sheet laminate preferably has a structure in which at least a part of the third filler is embedded in the adhesive layer. By further performing a thermocompression treatment, a cured multilayer resin sheet laminate is obtained (curing step). The conditions for thermocompression in the curing step are not specifically limited as long as the resin layer is cured. For example, preferably, the treatment is performed at a heating temperature of from 80°C to 250°C, a pressure of from 1 MPa to 100 MPa, and a treatment time of from 0.1 minutes to 360 minutes. More preferably, the treatment is performed at a temperature of from 100°C to 200°C, a pressure of from 1.5 MPa to 80 MPa, and a treatment time of from 10 minutes to 240 minutes.
The curing step may be performed under atmospheric pressure (ordinary pressure), but is preferably performed under reduced pressure. The reduced pressure condition is preferably 30000 Pa or less, more preferably 10000 Pa or less.

After the curing step, a further heat treatment may be performed for further improving thermal conductivity and heat resistance. The heat treatment can be performed at a temperature of from 100°C to 250°C for from 10 minutes to 300 minutes, for example. From the viewpoint of thermal conductivity, the temperature for the heat treatment preferably includes a temperature at which an epoxy resin having a mesogenic group tends to be oriented. In particular, the heat treatment preferably includes at least two steps of heating at from 100°C to 160°C and at from 160°C to 250°C; more preferably at least three steps of heating at from 100°C to less than 150°C, at from 150°C to less than 180°C, and at from 180°C to 220°C.

### [Multilayer Resin Sheet with Third Filler Embedded in Adhesive Layer]

In a case in which the multilayer resin sheet has a structure in which at least a part of the third filler in the resin layer is embedded in the adhesive layer, the conditions for thermocompression are not specifically restricted. For example, preferably, the heating temperature is from 60°C to 200°C, the pressure is from 1 MPa to 100 MPa, and the treatment time is from 0.1 minutes to 360 minutes. From the viewpoint of maintaining thermal conductivity, preferably, the temperature is from 80°C to 180°C, the pressure is from 1 MPa to 30 MPa, and the treatment time is from 0.5 minutes to 240 minutes.

### [Multilayer Resin Sheet without Third Filler Embedded in Adhesive Layer]

In a case in which the multilayer resin sheet has a structure in which at least a part of the third filler in the resin layer is not embedded in the adhesive layer, a thermocompression treatment for allowing at least a part of the third filler in the resin layer to be embedded in the adhesive layer is preferably performed. The conditions for thermocompression in this case are as follows. Preferably, the heating temperature is from 60°C to 200°C, the pressure is from 0.5 MPa to 200 MPa, and the treatment time is from 0.1 minutes to 20 minutes. More preferably, the temperature is from 80°C to 180°C, the pressure is from 1 MPa to 100 MPa, and the treatment time is from 0.1 minutes to 15 minutes. In this manner, the multilayer resin sheet laminate in which at least a part of the third filler in the resin layer is embedded in the adhesive layer can be obtained.
The conditions for thermocompression in the laminate formation step are not specifically restricted. For example, the treatment is preferably performed at a heating temperature of from 100°C to 250°C, a pressure of from 1 MPa to 100 MPa, and a treatment time of from 0.1 minutes to 20 minutes. More preferably, the temperature is from 70°C to 220°C, the pressure is from 1 MPa to 60 MPa, and the treatment time is from 0.2 minutes to 10 minutes.

In the laminate formation step, at least a part of the third filler in the resin layer may be embedded in the adhesive layer during the laminate formation step. In this case, the conditions for thermocompression are as follows. Preferably, the heating temperature is from 60°C to 200°C, the pressure is from 1.5 MPa to 100 MPa, and the treatment time is from 0.1 minutes to 20 minutes. More preferably, the temperature is from 80°C to 180°C, the pressure is from 2 MPa to 80 MPa, and the treatment time is from 0.2 minutes to 20 minutes. From the viewpoint of reducing the number of steps, a method in which at least a part of the third filler in the resin layer is allowed to be embedded in the adhesive layer during the laminate formation step is preferable.

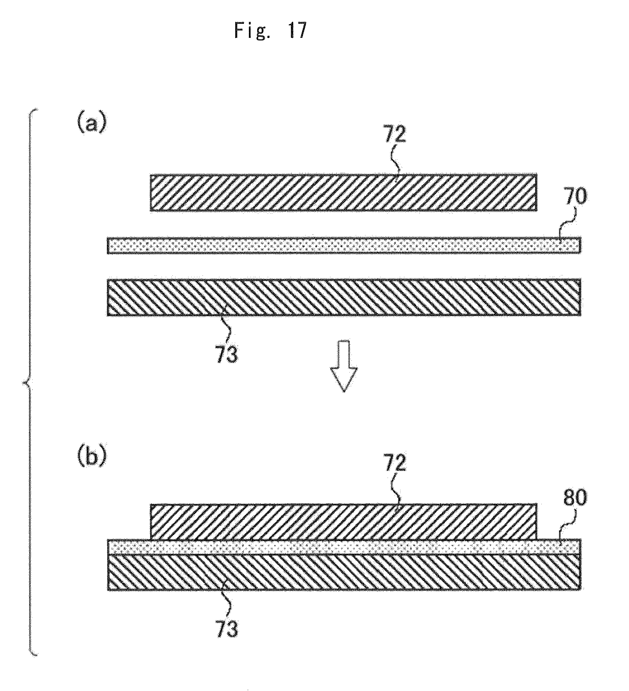

Adherends may be positioned on both sides of the multilayer resin sheet of the present invention, even if the adhesive layer is formed only on one side of the multilayer resin sheet. Also, adherends may be positioned on both sides of the multilayer resin sheet of the present invention when the adhesive layer is formed on both sides of the multilayer resin sheet. One example of the laminate formation step in these cases will be described with reference to drawings. As shown in Fig. 17(a), first adherend 72, multilayer resin sheet 70, and second adherend 73 are positioned in this order, and thermocompression is performed such that multilayer resin sheet 70 is sandwiched between first adherend 72 and second adherend 73, thereby obtaining a laminate in which first adherend 72, multilayer resin sheet 80, and second adherend 73 are layered in this order and bonded to each other, as shown in Fig. 17(b).

The adherend is not specifically restricted, and examples thereof include a metal such as copper, aluminum, chromium copper and a nickel-plated metal plate; a resin such as polyimide, epoxy, triazine, melanine, nylon and ABS; ceramics such as alumina, boron nitride, magnesium oxide, silicon nitride and aluminum nitride; and a composite material of a mixture of the materials.

The multilayer resin sheet of the present invention is capable of forming a cured multilayer resin sheet that is highly thermally conductive and is also capable to endure a harsh thermal shock during packaging or actual driving. Accordingly, the multilayer resin sheet of the present invention is expected to be applied in the fields in which a rapid growth in demand is anticipated, such as a heat radiator of an inverter for hybrid vehicles, a heat radiator of an inverter for industrial equipments, and a heat radiator for LED devices.

### <Cured Multilayer Resin Sheet>

The cured multilayer resin sheet of the present invention includes a cured resin layer that includes a filler and a cured resin derived from an epoxy resin monomer and a curing agent, and an adhesive layer positioned on at least one face of the cured resin layer. The filler includes a first filler having a volume average particle size of from 0.01 µm to less than 1 µm, a second filler having a volume average particle size of from 1 µm to less than 10 µm, and a third filler having a volume average particle size of from 10 µm to 100 µm and including boron nitride. Further, at least a part of the third filler is embedded in the adhesive layer.

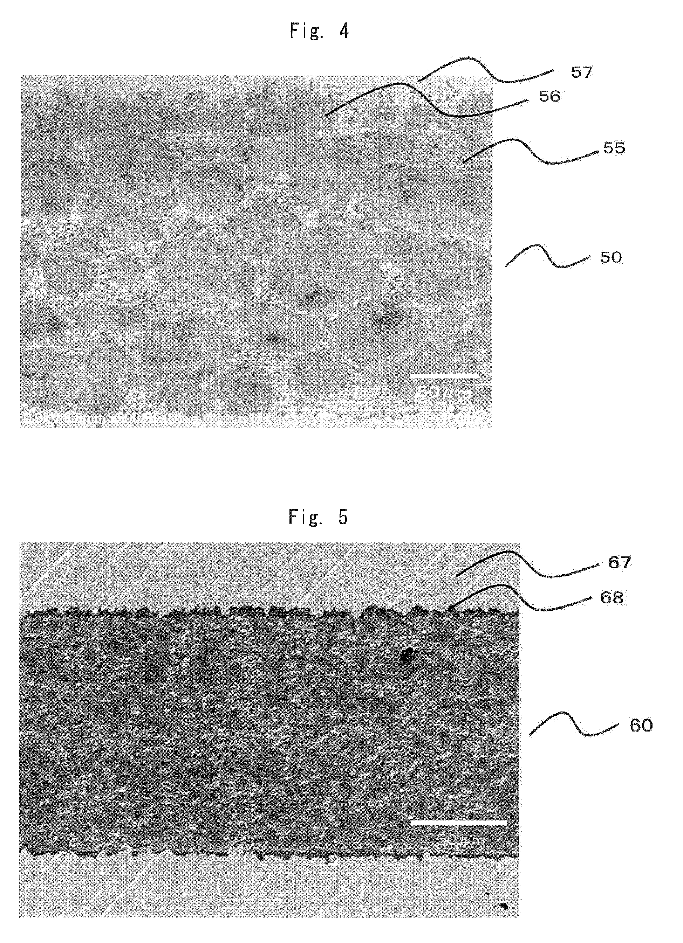

In the present invention, preferably, at least a part of the third filler is in contact with each other in a point-like manner in the resin layer, and more preferably, at least a part of the third filler is in contact with each other in a face-to-face manner such that the filler can conduct heat among each other. The term "in contact with each other in a face-to-face manner such that the filler can conduct heat" refers to a state in which the third filler particles exist close to each other and are deformed so as to face each other, as shown in one example of the cross-sectional SEM photograph of the cured multilayer resin sheet in Fig. 5. Since at least a part of the third filler particles are in contact with each other, thermal conductivity is more improved. Moreover, it is seen that, in the vicinity of an interface between copper foil 57 that is an adherend and the multilayer resin sheet, third filler 56 is deformed along with the shape of a surface of copper foil 57. Further, it is seen that third filler 56 is connected to the filler near the center of the sheet, whereby a network of the filler is formed. It is considered that boron nitride contained in the third filler has a thermal conductivity of at least 100 times greater than that of the resin in itself. By forming the network of the filler, a thermal conducting path is formed without intervention of resin, whereby thermal conductivity can be remarkably improved. In contrast, in a case of a rigid filler such as alumina, the filler may fail to approach an interface with an adherend such as a copper foil, because of lack of deformability. As a result, it is considered that it is difficult to form a network of a filler, and thus it is difficult to improve thermal conductivity. In view of the above, the filler preferably include boron nitride that is a deformable filler.

In addition, the deformed filler exists in the adhesive layer that is low in thermal conductivity. However, since a filler network is formed, the thermal conductivity is hardly affected by the resin in the adhesive layer. The reason for this is that a thermally conductive path is formed and heat is conducted via the filler, as previously described.
Incidentally, Fig. 5 is a cross-sectional SEM photograph of the cured multilayer resin sheet formed by performing a thermocompression treatment after attaching copper foils as adherends to both faces of the multilayer resin sheet.

In the present invention, it is also preferred that not only the third filler but also at least a part of the filler including the first filler and the second filler is in contact with each other. For example, the first filler may be in contact with the first filler, or the first filler may be in contact with the third filler.

Examples of a method for forming the cured resin layer such that at least a part of the third filler is in contact with each other include a method in which the content of the filler in the resin layer is appropriately selected; a method in which the mixing ratio of the filler, especially the mixture ratio of a soft filler and a rigid filler, is appropriately selected; and a method in which the resin layer including the filler is subjected to a thermocompression treatment. These methods may be combined, as necessary.

In cured multilayer resin sheet 20 of the present invention, as shown in the schematic cross-sectional diagram of Fig. 2, at least a part of the third filler particles is embedded in adhesive layer 3. Namely, at least a part of third filler 4, which is positioned in the vicinity of a surface of a face opposed to adhesive layer 3, is in a state that the particles are partially embedded in adhesive layer 3, whereby the particles exist both in cured resin layer 2A and adhesive layer 3. It is possible for third filler 4 that is embedded in adhesive layer 3 to be positioned closer to the outermost surface of adhesive layer 3. However, as shown in Fig. 2, it is preferred that the third filler is not exposed on the outermost surface of cured multilayer resin sheet 20, and that the surface of cured multilayer resin sheet 20 is covered with a cured material of adhesive layer 3.

Since at least a part of the third filler is embedded in the adhesive layer, thermal conductivity of the cured multilayer resin sheet as a whole is improved, and excellent adhesion and insulation properties are achieved.
A part of the third filler is positioned in a region other than the vicinity of a surface of a face opposed to the adhesive layer, and exists only in the resin layer. It is preferred that the third filler in the resin layer is in contact with each other, including the third filler that is embedded in the adhesive layer, more preferably in a thermally conductive manner.

The state in which the third filler is embedded in the adhesive layer may be a state in which the third filler is exposed from the resin layer and embedded in the adhesive layer such that particles of the third filler exist in both the resin layer and the adhesive layer and contact the resin layer and the adhesive layer; a state in which the third filler is included in the adhesive layer together with a resin component that forms the resin layer, and particles of the third filler contact the adhesive layer via the resin component that forms the resin layer; or a state in which both cases coexist.

Whether or not at least a part of the third filler in the resin layer is embedded in the adhesive layer can be determined by, for example, observing a cross-section that is perpendicular to an interface between the resin layer and the adhesive layer of the cured multilayer resin sheet with a scanning electron microscope (SEM) and an electron beam X-ray microanalyzer (XMA), and analyzing based on the state of distribution of the filler, the borderline between the resin layer and the adhesive layer, and the structure thereof. Alternatively, the adhesive layer and a thermally-conductive layer can be separated by detecting an element that exists only in the adhesive layer. For example, in a case in which a silicon-modified polyamide-imide resin is used for the adhesive layer, the interface can be determined by detecting the silicon element. In a case in which the material is unknown, the detection may be carried out by combining chemical analyses such as infrared microspectroscopy, elemental analysis and mass analysis. For example, it is considered to be possible to analyze the components by separating the resin component and the filler component by infrared spectroscopy, and then analyzing by combining mass analysis, spectroscopic analysis, and chemical analyses. By separating the adhesive layer and the thermally-conductive layer by the methods as described above, it is possible to confirm whether or not at least a part of the third filler is embedded in the adhesive layer.

### <Resin Sheet Laminate>

The resin sheet laminate of the present invention includes the cured multilayer resin sheet and a metal plate or a radiator plate that is positioned on at least one face of the cured multilayer resin sheet. Because of such a configuration, the resin sheet laminate exhibits excellent thermal conductivity and insulation properties, and also a favorable adhesion between the cured multilayer resin sheet and the metal plate or the radiator plate. Moreover, the resin sheet laminate is highly resistant to a thermal shock.

Details of the cured multilayer resin sheet laminate are as described above. Examples of the metal plate or the radiator plate include a copper plate, an aluminum plate, and a ceramic plate. The thickness of the metal plate or the radiator plate is not specifically limited. A metal foil such as a copper foil or an aluminum foil may be used as the metal plate or the radiator plate.
In the present invention, the metal plate or the radiator plate is positioned on at least one face of the cured multilayer resin sheet, but the metal plate or the radiator plate is preferably positioned on both faces of the cured multilayer resin sheet.

### <Method for Producing Resin Sheet Laminate>

The method for producing the resin sheet laminate of the present invention includes: a step of positioning the metal plate or the radiator plate on the adhesive layer of the multilayer resin sheet; and a step of curing the resin layer by applying heat to the multilayer resin sheet. Details of the steps are as described above.

The following are exemplary configurations of power semiconductor devices employing the cured multilayer resin sheet of the present invention.

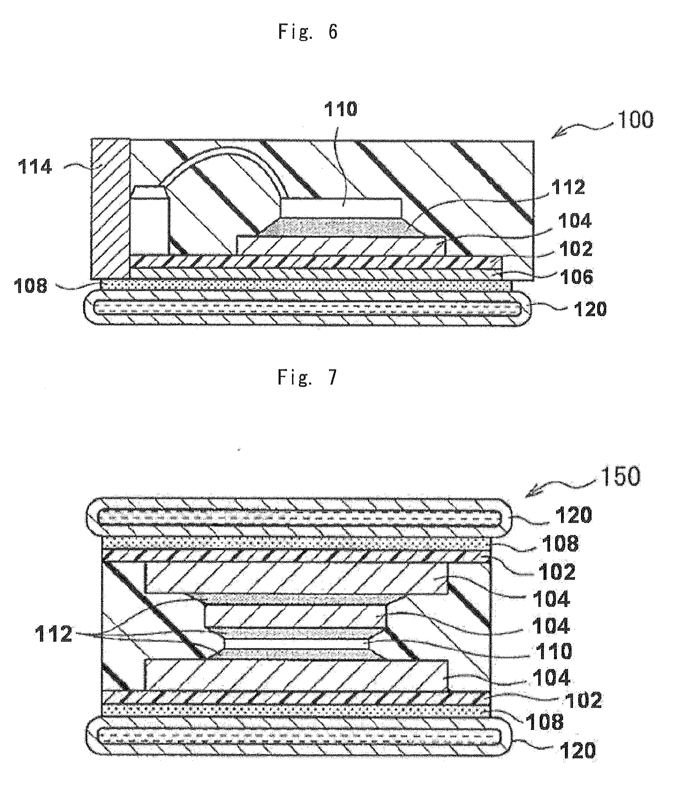

Fig. 6 is a schematic cross-sectional diagram showing an example of a configuration of power semiconductor device 100 in which copper plate 104 over which power semiconductor chip 110 is positioned via solder layer 112, cured multilayer resin sheet of the present invention 102, and radiation base 106 positioned over water-cooling jacket 120 via grease layer 108 are layered. Since a heat generator, including power semiconductor chip 110, is in contact with a heat radiating member via the cured multilayer resin sheet of the present invention 102, heat can be released in an efficient manner. Radiation base 106 may be formed from a thermally conductive material such as copper or aluminum. Examples of the power semiconductor chip include an IGBT and a thyristor.

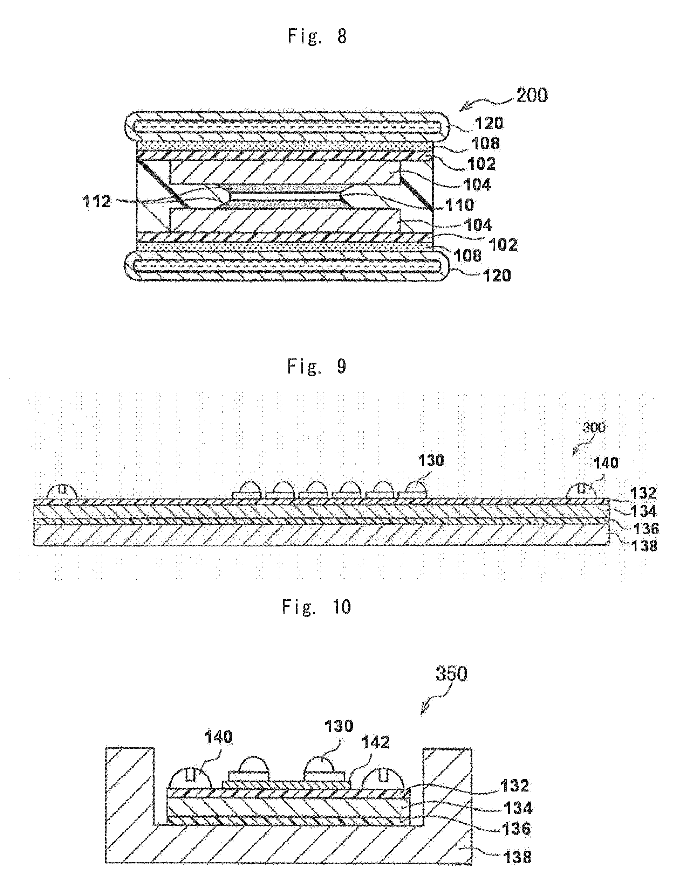

Fig. 7 is a schematic cross-sectional diagram showing an example of a configuration of power semiconductor device 150 having a structure in which cooling members are positioned on both faces of power semiconductor chip 110. In power semiconductor device 150, the cooling member positioned on the upper face of power semiconductor chip 110 includes two copper plates 104. Due to a configuration such as this, chip breakage or solder fracture can be suppressed more effectively. In Fig. 8, cured multilayer resin sheet 102 and water-cooling jacket 120 are positioned via grease layer 108, but it is also possible that cured multilayer resin sheet 102 and water-cooling jacket 120 are in direct contact with each other.
Fig. 8 is a schematic cross-sectional diagram showing an example of a configuration of power semiconductor device 200 having a structure in which cooling members are positioned on both faces of power semiconductor chip 110. In power semiconductor device 200, the cooling members positioned on both faces of power semiconductor chip 110 include one copper plate 104, respectively. In Fig. 9, cured multilayer resin sheet 102 and water-cooling jacket 120 are positioned via grease layer 108, but it is also possible that cured multilayer resin sheet 102 and water-cooling jacket 120 are in direct contact with each other.

Fig. 9 is a schematic cross-sectional diagram showing an example of a configuration of LED light bar 300 configured by using the cured resin of the present invention. LED light bar 300 has a structure in which housing 138, grease layer 136, aluminum substrate 134, resin sheet of the present invention 132, and LED chips 130 are positioned in this order. By positioning LED chips 130, which is a heat generator, over aluminum substrate 134 via cured multilayer resin sheet of the present invention 132, heat can be released in an efficient manner.

Fig. 10 is a schematic cross-sectional diagram showing an example of a configuration of light emitting section 350 of an LED bulb. Light emitting section 350 of the LED bulb has a structure in which housing 138, grease layer 136, aluminum substrate 134, cured multilayer resin sheet of the present invention 132, circuit layer 142, and LED chips 130 are positioned in this order.

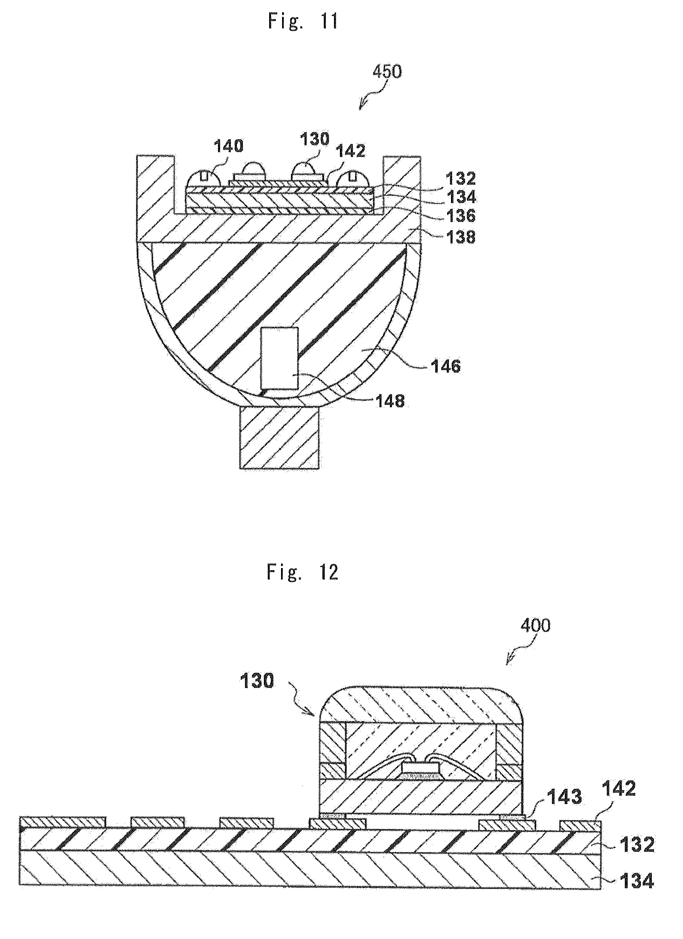

Fig. 11 is a schematic cross-sectional diagram showing an example of an entire configuration of LED bulb 450.

Fig. 12 is a schematic cross-sectional diagram showing an example of a configuration of LED substrate 400. LED substrate 400 has a structure in which aluminum substrate 134, cured multilayer resin sheet of the present invention 132, circuit layer 142 and LED chips 130 are positioned in this order. By positioning LED chips 130, which are heat generators, over aluminum substrate 134 via the circuit layer and cured multilayer resin sheet of the present invention 132, heat can be released in an efficient manner.

### EXAMPLES

In the following, the present invention will be described with reference to the Examples, but the present invention is not limited to the Examples. The "part" and "%" are based on mass standard, unless otherwise noted.
The epoxy resin monomer was synthesized in view of the methods described in JP-A No. 2005-206814, JP-A No. 2005-29778 and the like. The catechol resorcinol novolac resin was produced in view of the methods described in JP-A No. 2006-131852, JP-A No. 2010-518183 and the like.

Materials used for producing a multilayer resin sheet and abbreviations thereof are as follows.

### <Resin Layer>

### (Inorganic Filler)

·AA-18: aluminum oxide, product name: AA-18, manufactured by Sumitomo Chemical Co., Ltd., volume average particle size: 18 µm
·AA-3: aluminum oxide, product name: AA-3, manufactured by Sumitomo Chemical Co., Ltd., volume average particle size: 3 µm
·AA-04: aluminum oxide, product name: AA-04, manufactured by Sumitomo Chemical Co., Ltd., volume average particle size: 0.4 µm
·FS-3: boron nitride, product name: FS-3, manufactured by Mizushima Ferroalloy Co., Ltd., volume average particle size: 76 µm
·HP-40: boron nitride, product name: HP40MF100, manufactured by Mizushima Ferroalloy Co., Ltd., volume average particle size: 45 µm
·PTX-25: boron nitride, product name: PTX-25, manufactured by Momentive Performance Materials Inc., volume average particle size: 25 µm

### (Curing Agent)

·CRN: catechol resorcinol novolac resin (containing 50% of cyclohexanone (CHN)), synthesized

### (Epoxy Resin Monomer)

·BPGE: 4,4'-biphenol epoxy resin, product name: YL6121 H, manufactured by Mitsubishi Chemical Corporation
·PNAP: triphenylmethane epoxy resin, product name: EPPN-502H, manufactured by Nippon Kayaku Co., Ltd.
·MOPOC:
   1-{(3-methyl-4-oxiranylmethoxy)phenyl}-4-(4-oxiranylmethoxyphenyl)-1-cyclohexene, synthesized
The MOPOC was prepared in view of the methods described in JP-A No. 2005-206814, JP-A No. 2005-29778 and the like.

### (Additive)

·TPP: triphenylphosphine (manufactured by Wako Pure Chemical Industries, Ltd.)
·PAM: 3-phenylaminopropyltrimethoxysilane (silane coupling agent, product name: KBM-573, manufactured by Shin-Etsu Chemical Co., Ltd.)

### (Solvent)

·MEK: methylethylketone (manufactured by Wako Pure Chemical Industries, Ltd., extra pure grade)
·CHN: cyclohexanone (manufactured by Wako Pure Chemical Industries, Ltd., extra pure grade)

### (Support)

·PET film: product name: 75E-0010CTR-4, manufactured by Fujimori Kogyo Co., Ltd.
·Copper foil: product name: GTS 080, manufactured by Furukawa Electric Co., Ltd., thickness: 80 µm

### <Adhesive Layer>

### (Material for Modified Polyamide-imide Adhesive Layer)

·KS-7003: modified polyamide-imide varnish, product name: KS-7003, manufactured by Hitachi Chemical Co., Ltd. (solid content: 40%)

### (Material for Epoxy Resin Adhesive Layer)

### (Filler)

·A0802: aluminum oxide, product name: AO802, manufactured by Toyo Ink Co., Ltd., volume average particle size: 0.7 µm, solid content: 76%

### (Coupling Agent)

·A-189: mercapto-terminated silane coupling agent, product name: A-189, manufactured by Nippon Unicar Co., Ltd.
·A-1160: ureido-terminated silane coupling agent, product name: A-1160, manufactured by Nippon Unicar Co., Ltd. (solid content: 50%)

### (Epoxy Resin Monomer)

·YD-8170C: bisphenol F epoxy resin, product name: YD-8170C, manufactured by Tohto Kasei Co., Ltd.
·YDCN-703: cresol novolac epoxy resin, product name: YDCN-703, manufactured by Tohto Kasei Co., Ltd. (solid content: 60%)

### (Curing Agent)

·LF-2882: bisphenol A novolac, product name: LF-2882, manufactured by DIC Corporation (solid content: 60%)

### (Curing Accelerator)

.2-phenyl-4-cyanoimidazole: 2PZ-CN, manufactured by Shikoku Chemicals Corporation

### (Acrylic Modified Rubber)

·HTR-860P-3: acrylic rubber, product name: HTR-860P-3, manufactured by Nagase ChemteX Corporation (solid content: 12%)

### (Solvent)

·CHN: cyclohexanone (manufactured by Wako Pure Chemical Industries, Ltd., extra pure grade)

### (Support)

·PET film: product name: A31, manufactured by Teijin DuPont Films Japan Limited

### (Synthesis of Novolac Resin)

### <Synthesis Example 1>

In a separable flask, 105 g (0.95 mol) of resorcinol and 5 g (0.05 mol) of catechol as monomers, 0.11 g (0.1 wt%) of oxalic acid as a catalyst, and 15 g of methanol as a solvent were placed and mixed under a nitrogen atmosphere. While cooling in an oil bath such that the temperature was maintained at 40°C or less, 30 g (approximately 0.33 mol, F/P = 0.33) of formalin were added. After stirring for 2 hours, the temperature of the oil bath was elevated to 100°C, and water and methanol were distilled away under reduced pressure while heating. After confirming that distillation was completed, a solution of catechol resorcinol novolac resin (CRN) in which the mass ratio with respect to novolac resin was 50% was prepared by adding CHN.
The number average molecular weight of the obtained product was 484 and the number of repeating unit thereof was n = 3.9, according to the molecular weight measurement by GPC. The ratio of monomer content was 40%. According to ¹H-NMR measurement, the number of hydroxy groups in each repeating unit was 2.1. The hydroxy equivalent was 62 g/eq.

### <Example 1a>

### (Preparation of Resin Layer)

42.91 parts of an aluminum oxide mixture (AA-3 (second filler):AA-04 (first filler); mixture ratio by volume was 2.4:1), 46.04 parts of boron nitride (FS-3, third filler) (mixture ratio by volume with respect to AA-04 was 6.6:1), 0.13 parts of a silane coupling agent (PAM; KBM-573), 11.96 parts of a CHN solution of CRN having a monomer content of 40% (solid content: 50%) as a curing agent (novolac resin: synthetic compound), 44.77 parts of MEK, and 9.29 parts of CHN were mixed. After confirming that the components were mixed uniformly, 19.39 parts of MOPOC as an epoxy resin monomer and 0.20 parts of TPP were added and mixed. Thereafter, the mixture was subjected to ball mill crushing for from 40 hours to 60 hours, thereby obtaining a coating liquid for forming a resin layer as a resin composition.

The obtained coating liquid for forming a resin layer was applied onto a releasing surface of a PET (polyethylene terephthalate) film with a Comma Coater (manufactured by Hirano Tecseed Co., Ltd) to a thickness of approximately 110 µm, and the organic solvent was removed by drying in a box-type oven at a temperature of 100°C for 10 minutes, thereby forming a resin layer on the PET film.

Two PET films having a resin layer obtained by the process as described above were layered such that the resin layers were positioned to face each other, and a thermocompression treatment was performed with a hot press machine (hot plate: 130°C, pressure: 1 MPa, treatment time: 1 minute). Thereafter, the PET films were peeled off, thereby obtaining a resin layer in a B-stage state having a thickness of 200 µm.

### (Preparation of Adhesive Layer 1: Polyamide-imide Resin Adhesive Layer)

A modified polyamide-imide resin varnish (manufactured by Hitachi Chemical Co., Ltd., trade name: KS7003, solid content: 40%) was applied onto a PET film 31A to which release treatment was performed, with a Comma Coater (manufactured by Hirano Tecseed Co., Ltd). An adhesive layer was formed on the PET film by drying the varnish in a conveyor-type drying oven in which a temperature was set at 130°C to 140°C for approximately 8 minutes, thereby obtaining an adhesive film. Two types of adhesive layers 1, having thicknesses after drying of 6 µm and 12 µm, respectively, were prepared by adjusting the gap between the Comma Coater and the PET film.

### (Preparation of Adhesive Layer 2: Epoxy Adhesive Layer)

24.2 parts of YD-8170C and 13.5 parts of YDCN-703 as epoxy resins, 30.67 parts of LF-2882 as a curing agent, 0.083 parts of 2PZCN as a curing accelerator, 196.53 parts of HTR-860P-3 as an acrylic modified rubber, 0.21 parts of A-189 and 0.83 parts of A-1160 as coupling agents, and 231.58 parts of AO802 as a filler were weighed and mixed in a mixer for 1 hour, thereby obtaining a coating liquid for an adhesive layer. Next, the coating liquid was applied onto a PET film 31A to which release treatment was performed, with a Comma Coater (manufactured by Hirano Tecseed Co., Ltd). An adhesive layer was formed on the PET film by drying the coating liquid in a conveyor-type drying oven in which the temperature was set to be 100°C for approximately 6 minutes, whereby adhesive layer 2 was prepared. The thickness of adhesive layer 2 after drying was 10 µm.

### (Production of Multilayer Resin Sheet)

The PET films having adhesive layer 1 formed thereon were attached to both faces of the resin layer in a B-stage state, such that the adhesive layers were positioned to face the B-stage sheet. Then, adhesive layers 1 each having a thickness of 6 µm were bonded to the resin layer with a laminator (manufactured by Meiki Co., Ltd, MVLP-600/700) at a temperature of 120°C, a pressure of 1.0 MPa, a degree of vacuum of 1 kPa or less, and a treatment time of 15 seconds, thereby obtaining a multilayer resin sheet in a B-stage state.

The PET films were peeled off from the multilayer resin sheet obtained as above, and copper foils having a thickness of 80 µm were placed on both faces of the multilayer resin sheet and a pressing treatment was performed (hot plate temperature: 165°C, degree of vacuum: 1 kPa or less, pressure: 10 MPa, treatment time: 3 minutes). Thereafter, the multilayer resin sheet was placed in a box-type oven and step-curing was performed at a temperature of 140°C for 2 hours, at a temperature of 165°C for 2 hours, and at a temperature of 190°C for 2 hours. Cured multilayer resin sheet 1a, having copper foils on both faces thereof, was obtained as a resin sheet laminate.
Fig. 4 is a cross-sectional observation photograph of cured multilayer resin sheet 1a obtained with a scanning electron microscope. As shown in Fig. 4, a mixture of the first filler and the second filler 55 is present in the cured resin layer of cured multilayer resin sheet 50. Further, a part of third filler 56 is embedded in adhesive layer 57. The state shown in Fig. 4 is explained in a schematic manner with reference to Fig. 1 and Fig. 2.

A schematic cross-sectional diagram of the resin layer before being provided with adhesive layers is shown in Fig. 1. As shown in Fig. 1, in resin layer 10, filler 1 is dispersed in resin composition 2.
A schematic cross-sectional diagram of the cured multilayer resin sheet 20, which is obtained by performing a pressing treatment to a multilayer resin sheet having adhesive layers 3 on both faces, is shown in Fig. 2. As shown in Fig. 2, in cured multilayer resin sheet 20 after pressing treatment, a part of third filler 4 is embedded in adhesive layer 3. Further, in cured resin layer 2A, a part of the third filler is deformed and in contact with each other.

### <Experiment 1b>

Cured multilayer resin sheet 1b having copper foils on both faces thereof was obtained in a similar manner to Experiment 1 a, except that the thickness of adhesive layers 1 was changed to 12 µm.

### <Experiments 1c and 1d>

Cured multilayer resin sheets 1c and 1d each having copper foils on both faces thereof were obtained in a similar manner to Experiments 1a and 1b, except that the pressing treatment conditions were changed (hot plate temperature: 165°C, degree of vacuum: 1 kPa or less, pressure: 1 MPa, treatment time: 3 minutes), respectively.
In the obtained cured multilayer resin sheets 1c and 1d, the third filler in the resin layer was not embedded in the adhesive layer.

### <Experiment 2a>

Cured multilayer resin sheet 2a having copper foils on both faces thereof was obtained in a similar manner to Experiment 1a, except that 46.04 parts of a boron nitride mixture (FS-3:HP-40 =1:1 (mass ratio), third filler) (mixture ratio by volume with respect to AA-04 was 3.3:3.3:1) was used in place of 46.04 parts of boron nitride (FS-3, third filler).

### <Experiment 2b>

Cured multilayer resin sheet 2b having copper foils on both faces thereof was obtained in a similar manner to Experiment 2a, except that the thickness of adhesive layers 1 was changed to 12 µm.

### <Experiments 2c and 2d>

Cured multilayer resin sheets 2c and 2d each having copper foils on both faces thereof were obtained in a similar manner to Experiments 2a and 2b, except that the pressing treatment conditions were changed (hot plate temperature: 165°C, degree of vacuum: 1 kPa or less, pressure: 1 MPa, treatment time: 3 minutes), respectively.
In the obtained cured multilayer resin sheets 2c and 2d, the third filler in the resin layer was not embedded in the adhesive layer.

### <Experiment 3a>

Cured multilayer resin sheet 3a having copper foils on both faces thereof was obtained in a similar manner to Experiment 1a, except that 46.04 parts of boron nitride (HP-40, third filler) (mixture ratio by volume with respect to AA-04 was 6.6: 1) was used in place of 46.04 parts of boron nitride (FS-3).

### <Experiment 3b>

Cured multilayer resin sheet 3b having copper foils on both faces thereof was obtained in a similar manner to Experiment 3a, except that the thickness of adhesive layers 1 was changed to 12 µm.

### <Experiment 3c>

Cured multilayer resin sheet 3c having copper foils on both faces thereof was obtained in the same manner as Experiment 3a, except that adhesive layer 2 was used.

### <Experiments 3 d, 3e and 3f>

Cured multilayer resin sheets 3d, 3e and 3f, each having copper foils on both faces thereof, were obtained in a similar manner to Experiments 3a, 3b and 3c, respectively, except that the pressing treatment conditions were changed (hot plate temperature: 165°C, degree of vacuum: 1 kPa or less, pressure: 1 MPa, treatment time: 3 minutes).
In the obtained cured multilayer resin sheets 3d, 3e and 3f, the third filler in the resin layer was not embedded in the adhesive layer.
A cross-sectional observation photograph of cured multilayer resin sheet 3d obtained with a scanning electron microscope is shown in Fig. 5. It is seen that the third filler is not embedded in adhesive layer 68 that is immediately below copper foil 67. The state as shown in Fig. 5 is explained in a schematic manner with reference to Fig. 3. As shown in Fig. 3, although filler 1 exists in cured resin layer 2A, it is not embedded in adhesive layer 3.

### <Experiment 4a>

Cured multilayer resin sheet 4a having copper foils on both faces thereof was obtained in a similar manner to Experiment 1a, except that 46.04 parts of boron nitride (PTX-25, third filler) (mixture ratio by volume with respect to AA-04 was 6.6:1) was used in place of 46.04 parts of boron nitride (FS-3).

### <Experiment 4b>

Cured multilayer resin sheet 4b having copper foils on both faces thereof was obtained in a similar manner to Experiment 4a, except that the thickness of adhesive layers 1 was changed to 12 µm.

### <Experiments 4c and 4d>

Cured multilayer resin sheets 4c and 4d, each having copper foils on both faces thereof, were obtained in a similar manner to Experiments 4a and 4b, respectively, except that the pressing treatment conditions were changed (hot plate temperature: 165°C, degree of vacuum: 1 kPa or less, pressure: 1 MPa, treatment time: 3 minutes).
In the obtained cured multilayer resin sheets 4c and 4d, the third filler in the resin layer was not embedded in the adhesive layer.

### <Experiment 5a>

Cured multilayer resin sheet 5a having copper foils on both faces thereof was obtained in a similar manner to Experiment 3a, except that a multilayer resin sheet in a B-stage state was obtained with a pressing machine (manufactured by Imoto Machinery Co., Ltd., IMC-1823 Model) in place of the laminator, setting the treatment conditions to a hot plate temperature of 165°C, a degree of vacuum of 1 kPa or less, a pressure of 10 MPa, and treatment time of 3 minutes; and that the pressing treatment conditions for the obtained multilayer resin sheet in a B-stage state were set to a hot plate temperature of 180°C, a degree of vacuum of 1 kPa or less, a pressure of 10 MPa, and a treatment time of 3 minutes.

### <Experiment 5b>

Cured multilayer resin sheet 5b having copper foils on both faces thereof was obtained in a similar manner to Experiment 5a, except that the thickness of adhesive layers 1 was changed to 12 µm.

### <Experiment 6a>

Cured multilayer resin sheet 6a having copper foils on both faces thereof was obtained in a similar manner to Experiment 5a, except that 19.52 parts of BPGE were used in place of 19.39 parts of MOPOC as an epoxy resin monomer, and that the amount of curing agent 1 was changed to 11.52 parts.

### <Experiment 6b>

Cured multilayer resin sheet 6b having copper foils on both faces thereof was obtained in a similar manner to Experiment 6a, except that the thickness of adhesive layers 1 was changed to 12 µm.

### <Experiment 7a>

Cured multilayer resin sheet 7a having copper foils on both faces thereof was obtained in a similar manner as Experiment 5a, except that 17.38 parts of PNAP were used in place of 19.39 parts of MOPOC as an epoxy resin monomer, and that the amount of curing agent 1 was changed to 13.06 parts.

### <Experiment 7b>

Cured multilayer resin sheet 7b having copper foils on both faces thereof was obtained in a similar manner to Experiment 7a, except that adhesive layers 2 were used in place of adhesive layers 1.

### <Experiment 8a>

### (Formation of Resin Layer)

A coating liquid for forming a resin layer was produced in a similar manner to Experiment 7a. The coating liquid was applied onto a releasing surface of a PET (polyethylene terephthalate) film with a Comma Coater to a thickness of approximately 110 µm, and a resin layer was formed on the PET film by removing the organic solvent by drying in a box-type oven at a temperature of 100°C for 10 minutes.

The PET film on which the resin layer was formed and adhesive layer 1 having a thickness of 6 µm were layered such that the resin layers were positioned to face each other, and adhesive layer 1 was bonded to one face of the resin layer with a hot pressing machine at a hot plate temperature of 165°C, a degree of vacuum of 1 kPa or less, a pressure of 15 MPa, and a treatment time of 3 minutes, thereby obtaining a multilayer resin sheet in a B-stage state. The thickness of the resin layer of the obtained multilayer resin sheet was 105 µm.
Cured multilayer resin sheet 8a having copper foils on both faces thereof was obtained in a similar manner to Experiment 5a, except that the obtained multilayer resin sheet was used.

### <Experiment 8b>

Cured multilayer resin sheet 8b having copper foils on both faces thereof was obtained in a similar manner to Experiment 8a, except that adhesive layer 2 was used in place of adhesive layer 1.

### <Experiment 9a>

Cured multilayer resin sheet 9a having copper foils on both faces thereof was obtained in a similar manner to Experiment 1 a, except that a pressing machine (manufactured by Imoto Machinery Co., Ltd., IMC-1823 Model) was used in place of the laminator, changing the laminating treatment conditions to a hot plate temperature of 165°C, a degree of vacuum of 1 kPa or less, a pressure of 10 MPa, and treatment time of 3 minutes, and that the pressing treatment conditions were set to be a hot plate temperature of 165°C, a degree of vacuum of 1 kPa or less, a pressure of 1 MPa, and a treatment time of 3 minutes.

### <Experiment 9b>

Cured multilayer resin sheet 9b having copper foils on both faces thereof was obtained in a similar manner to Experiment 9a, except that the thickness of the adhesive layer was changed to 12 µm.

### <Experiment 10a>

Cured multilayer resin sheet 10a having copper foils on both faces thereof was obtained in a similar manner to Experiment 1a, except that 19.52 parts of BGPE were used in place of 19.39 parts of MOPOC as an epoxy resin monomer, and that the amount of the curing agent was changed to 11.71 parts.

### <Experiment 10b>

Cured multilayer resin sheet 10b having copper foils on both faces thereof was obtained in a similar manner to Experiment 10a, except that the thickness of the adhesive layer was changed to 12 µm.

### <Experiments 11>

Sheet-like cured resin 11 having copper foils on both faces thereof was obtained in a similar manner to Experiment 1a, except that adhesive layers were not provided on both faces of the B-stage sheet as a resin layer.

### <Experiment 12>

Sheet-like cured resin 12 having copper foils on both faces thereof was obtained in a similar manner to Experiment 2a, except that adhesive layers were not provided on both faces of the B-stage sheet as a resin layer.

### <Experiment 13>

Sheet-like cured resin 13 having copper foils on both faces thereof was obtained in a similar manner to Experiment 3a, except that adhesive layers were not provided on both faces of the B-stage sheet as a resin layer.

### <Experiment 14>

Sheet-like cured resin 14 having copper foils on both faces thereof was obtained in a similar manner to Experiment 4a, except that adhesive layers were not provided on both faces of the B-stage sheet as a resin layer.

### <Experiment 15a>

Cured multilayer resin sheet 15a having copper foils on both faces thereof was obtained in a similar manner to Experiment 11, except that 83.29 parts of aluminum oxide (AA-18, third filler) (mixture ratio by volume with respect to AA04 was 6.6:1), which has the same volume fraction as boron nitride, were used in place of 46.04 parts of boron nitride (FS-3) in the preparation of the resin layer.

### <Experiment 15b>

Cured multilayer resin sheet 15b having copper foils on both faces thereof was obtained in a similar manner to Experiment 1a, except that 83.29 parts of aluminum oxide (AA-18), which has the same volume Fraction as boron nitride, were used in place of 46.04 parts of boron nitride (FS-3) in the preparation of the resin layer.

### <Experiment 15c>

Cured multilayer resin sheet 15c having copper foils on both faces thereof was obtained in a similar manner to Experiment 15b, except that the thickness of adhesive layers 1 was changed to 12 µm.

### <Experiment 15d>

Cured multilayer resin sheet 15d having copper foils on both faces thereof was obtained in a similar manner to Experiment 15b, except that adhesive layers 2 were used.

### <Evaluation>

The following evaluations were performed with the cured multilayer resin sheets having copper foils on both faces thereof and multilayer resin sheets in a B-stage state. The results are shown in Table 1 to Table 3.

### (Thermal Conductivity)

Thermal conductivity was calculated from a product of measured values of density, specific heat and thermal diffusively, based on a heat conduction equation. The method of measuring thermal diffusively is as follows. From the obtained cured resin sheet having a copper foil, only copper was removed by etching with a sodium persulfate solution, whereby a sheet-like cured resin is obtained. The thermal diffusivity of the cured resin is measured by a flash method with NANOFLASH LFA447, manufactured by NETZSCH Inc. The measurement is performed at a measurement temperature of 25 ± 1°C, a measurement voltage of 270 V, an amplitude of 5000, and a pulse width of 0.06 ms.

The density was determined by an Archimedean method with a sheet-like cured resin obtained by removing a copper foil in a manner similar to the above. The specific heat was determined from a difference of input heat with a differential thermal analyzer (DSC), PYRIS 1, manufactured by PerkinElmer Co., Ltd. The measurement was carried out by using high purity alumina as a reference, under a nitrogen atmosphere, and at a rate of temperature increase of 5°C/min.

### (Dielectric Strength Voltage)

Copper foils formed on both faces of the cured multilayer resin sheet were removed by etching with a sodium persulfate solution, and a sheet-like cured resin was obtained. The dielectric strength voltage of the cured resin under an alternate current was measured with YST-243-100RHO, manufactured by Yamayo Shiken-ki. The measurement was performed at a rate of pressure increase of 1 kV/second and a measurement temperature of 23 ± 2°C, in FLUORINERT FC-77 (fluorinated inert fluid, manufactured by Sumitomo 3M Limited).

### (Shear Strength)

The PET films were peeled off from both faces of the multilayer resin sheet in a B-stage state, and metal plates were attached thereto for carrying out measurement of tensile shear bond strength in accordance with JIS K6850. Specifically, two copper plates each having a size of 100 mm x 25 mm x 3 mm were positioned so as to sandwich the multilayer resin sheet in a B-stage state having a size of 12.5 mm x 25 mm, and bonded and cured. The shear strength was measured by pulling the multilayer resin sheet with copper plates under conditions of a testing rate of 1 mm/min and a measurement temperature of 23°C with AGC-100 Model, manufactured by Shimadzu Corporation.
The bonding and curing were performed as follows. After performing vacuum hot pressing (hot plate temperature: 165°C, degree of vacuum: 1 kPa or less, pressure: 4 MPa, treatment time: 3 minutes), step-curing was performed in a box-type oven at a temperature of 140°C for 2 hours, at a temperature of 165°C for 2 hours, and at a temperature of 190°C for 2 hours.

### (Usable Time)

The usable time was evaluated by determining whether or not the multilayer resin sheet after being stored at room temperature for a predetermined time was bent without breaking when the multilayer resin sheet was pushed against a cylinder having a radius of 20 mm.

### (Filler in Adhesive Layer)

The state of the filler being embedded in the adhesive layer was evaluated as follows. Two samples of the multilayer resin sheet, one was in a B-stage state before the press curing treatment and another was in a cured state after the press hardening treatment, were prepared. Then, a cross-section of perpendicular to an interface between the resin layer and the adhesive layer of the two samples was observed with a scanning electron microscope (SEM, manufactured by Oxford Instruments plc., INCA ENERGY350) and an accompanying electron beam X-ray microanalyzer (XMA, accelerating voltage: 20 kV, evaporation material: Pt-Pd). The presence or absence of the filler being embedded in the adhesive layer was determined based on the distribution state of the filler, the interface between the resin layer and the adhesive layer, and the structure thereof.

### (Particle Size Distribution of Filler)

A dispersion was prepared by dissolving the multilayer resin sheet in a B-stage state in excess cyclohexanone. With a membrane filter, a solid component as a filler was separated from a liquid component. The particle size distribution of the filler was measured by wet laser diffractometry. Specifically, the filler was dispersed in water with an ultrasonic dispersing machine, and the measurement was performed 5 times with a laser diffraction/scattering particle size distribution analyzer manufactured by Beckman Coulter, Inc. (model number LS230), and quantitative determination was performed. Examples of a graph of the measured particle size distribution, with the particle size on the abscissa and the frequency on the ordinate, are shown in Fig. 18 and Fig. 19.

It was confirmed that the particle size distributions of the resin layers of the multilayer resin sheets obtained in Experiments 1a to 15d exhibited peaks in ranges of from 0.01 µm to less than 1 µm, from 1 µm to less than 10 µm, and from 10 µm to 100 µm, respectively.

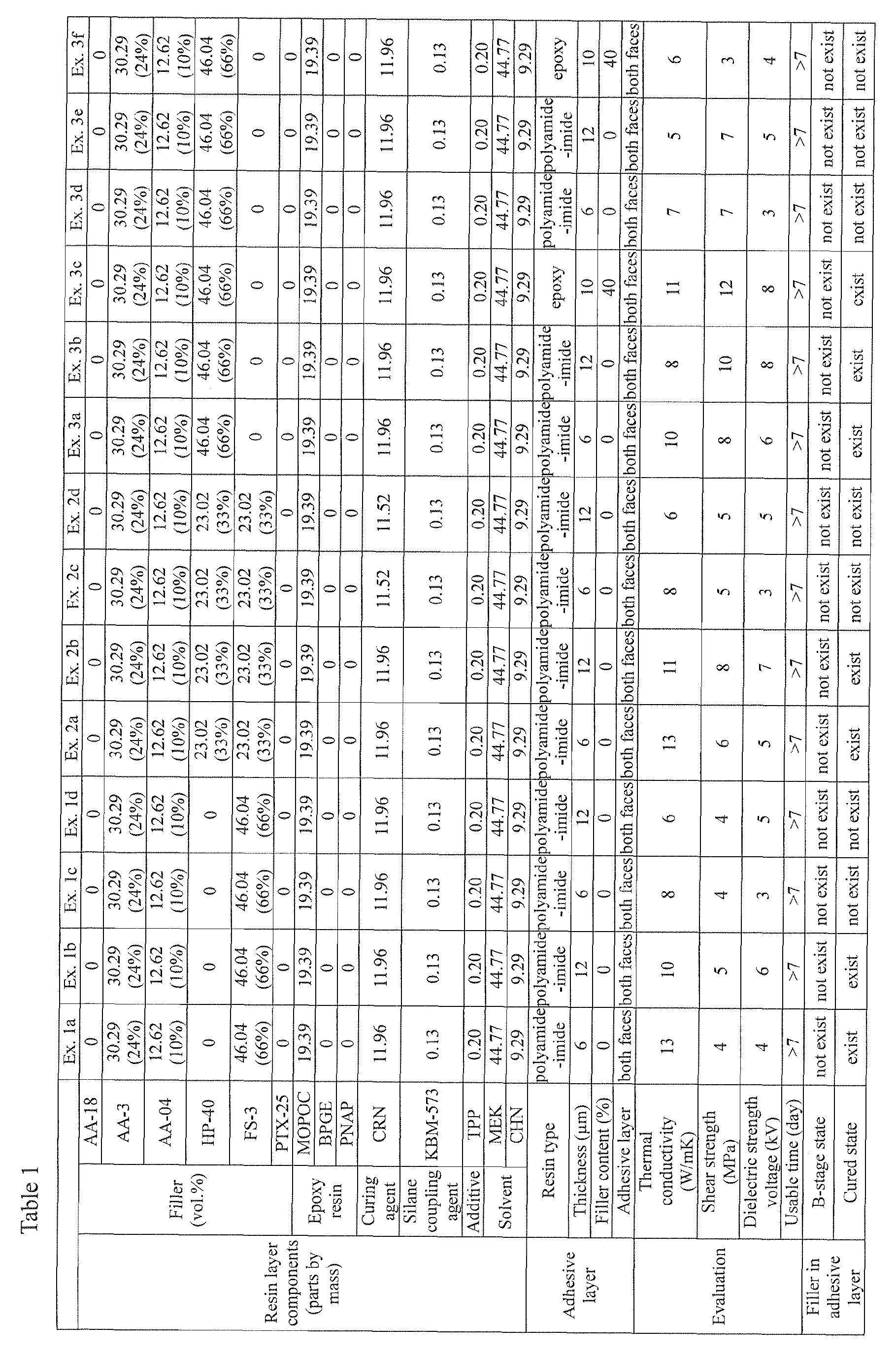

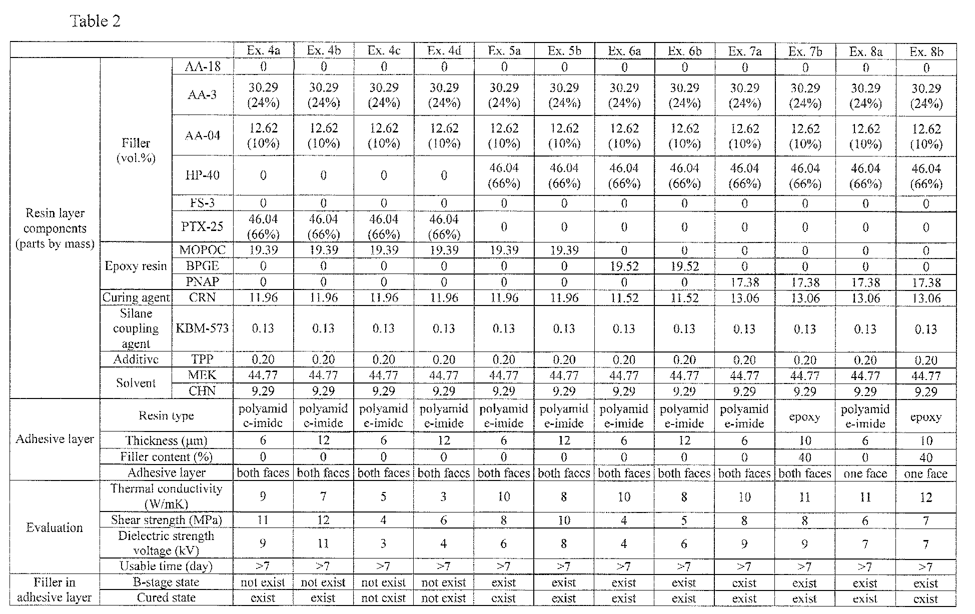

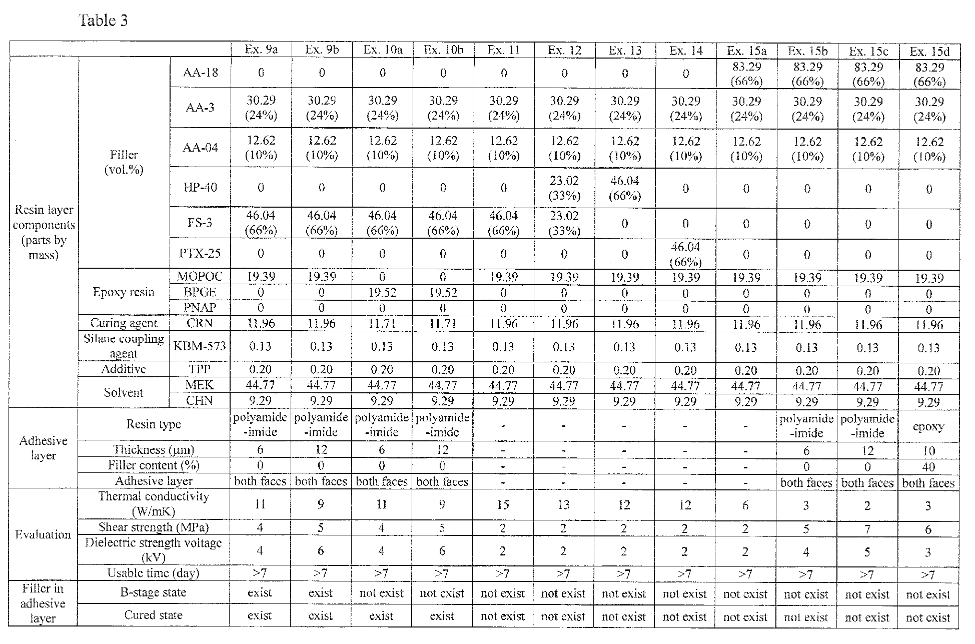

From Table 1 to Table 3 and Fig. 5 and Fig. 6, it is seen that the cured multilayer resin sheet, in which an adhesive layer is positioned on a surface of a resin layer and a filler in the resin layer is embedded in the adhesive layer by performing a heating-and-pressing treatment, exhibits a high thermal conductivity and an excellent balance in adhesive strength and a dielectric breakdown voltage. In contrast, it is seen that thermal conductivity is low when the filler in the resin layer is not embedded in the adhesive layer.

The disclosure of Japanese Patent Application No. 2010-226601 is incorporated herein by reference in its entirety. All documents, patent applications and technical standards described in the present description are incorporated herein by reference to the same extent as if each individual document, patent application and technical standard were specifically and individually indicated to be incorporated by reference.

## Claims

1. A multilayer resin sheet comprising:
a resin layer that includes an epoxy resin monomer, a curing agent, and a filler; and
an adhesive layer positioned on at least one face of the resin layer,
the filler having peaks in ranges of from 0.01 µm to less than 1 µm, from 1 µm to less than 10 µm, and from 10 µm to 100 µm, respectively, in terms of particle size distribution as measured by laser diffractometry, and
the filler having a particle size of from 10 µm to 100 µm including a boron nitride filler.

2. The multilayer resin sheet according to claim 1, wherein at least a part of the filler having a particle size of from 10 µm to 100 µm is embedded in the adhesive layer.

3. The multilayer resin sheet according to claim 1 or 2, wherein at least one of the epoxy resin monomer is an epoxy resin monomer having a mesogenic group, and at least one of the curing agent is a novolac resin.

4. The multilayer resin sheet according to any one of claims 1 to 3, wherein the adhesive layer includes at least one selected from the group consisting of a modified polyimide resin, a modified polyamide-imide resin and an epoxy resin.

5. A multilayer resin sheet comprising a resin layer and an adhesive layer positioned on at least one face of the resin layer, the resin layer including an epoxy resin monomer, a curing agent, a first filler having a volume average particle size of from 0.01 µm to less than 1 µm, a second filler having a volume average particle size of from 1 µm to less than 10 µm, and a third filler having a volume average particle size of from 10 µm to 100 µm and including a boron nitride filler.

6. The multilayer resin sheet according to claim 5, wherein at least a part of the third filler is embedded in the adhesive layer.

7. The multilayer resin sheet according to claim 5 or 6, wherein at least one of the epoxy resin monomer is an epoxy resin monomer having a mesogenic group, and at least one of the curing agent is a novolac resin.

8. The multilayer resin sheet according to any one of claims 5 to 7, wherein the adhesive layer includes at least one selected from the group consisting of a modified polyimide resin, a modified polyamide-imide resin and an epoxy resin.

9. A cured multilayer resin sheet comprising:
a cured resin layer that includes a filler and a cured resin that includes a reactant of an epoxy resin monomer and a curing agent; and
an adhesive layer positioned on at least one face of the cured resin layer,
the filler having peaks in ranges of from 0.01 µm to less than 1 µm, from 1 µm to less than 10 µm, and from 10 µm to 100 µm, respectively, in terms of particle size distribution as measured by laser diffractometry,
the filler having a particle size of from 10 µm to 100 µm including a boron nitride filler, and
at least a part of the filler having a particle size of from 10 µm to 100 µm being embedded in the adhesive layer.

10. The cured multilayer resin sheet according to claim 9, wherein at least a part of the filler having a particle size of from 10 µm to 100 µm is in contact with each other in the cured resin layer.

11. The cured multilayer resin sheet according to claim 9 or 10, wherein at least one of the epoxy resin monomer is an epoxy resin monomer having a mesogenic group, and at least one of the curing agent is a novolac resin.

12. The cured multilayer resin sheet according to any one of claims 9 to 11, wherein the adhesive layer includes at least one selected from the group consisting of a modified polyimide resin, a modified polyamide-imide resin and an epoxy resin.

13. A cured multilayer resin sheet comprising a cured resin layer and an adhesive layer positioned on at least one face of the cured resin layer,
the cured resin layer including a cured resin that includes a reactant of an epoxy resin monomer and a curing agent, a first filler having a volume average particle size of from 0.01 µm to less than 1 µm, a second filler having a volume average particle size of from 1 µm to less than 10 µm, and a third filler having a volume average particle size of from 10 µm to 100 µm and including a boron nitride filler, and
at least a part of the third filler being embedded in the adhesive layer.

14. The cured multilayer resin sheet according to claim 13, wherein at least a part of the third filler is in contact with each other in the cured resin layer.

15. The cured multilayer resin sheet according to claim 13 or 14, wherein at least one of the epoxy resin monomer is an epoxy resin monomer having a mesogenic group, and at least one of the curing agent is a novolac resin.

16. The cured multilayer resin sheet according to any one of claims 13 to 15, wherein the adhesive layer includes at least one selected from the group consisting of a modified polyimide resin, a modified polyamide-imide resin and an epoxy resin.

17. A method for producing a multilayer resin sheet, the method comprising:
a step of obtaining a resin layer that includes an epoxy resin monomer, a curing agent, a first filler having a volume average particle size of from 0.01 µm to less than 1 µm, a second filler having a volume average particle size of from 1 µm to less than 10 µm, and a third filler having a volume average particle size of from 10 µm to 100 µm and including a boron nitride filler;
a step of positioning an adhesive layer on at least one face of the resin layer; and
a step of allowing at least a part of the third filler to be embedded in the adhesive layer.

18. A resin sheet laminate comprising the cured multilayer resin sheet according to any one of claims 9 to 16, and a metal plate or a radiator plate positioned on at least one face of the cured multilayer resin sheet.

19. A method for producing a resin sheet laminate, the method comprising:
a step of obtaining a laminate by positioning a metal plate or a radiator plate on the adhesive layer of the multilayer resin sheet according to any one of claims 1 to 8; and
a step of allowing at least a part of the boron nitride filler to be embedded in the adhesive layer.

20. A metal-foil-cladded multilayer resin sheet comprising the multilayer resin sheet according to any one of claims 1 to 8 and a metal foil positioned on the adhesive layer of the multilayer resin sheet.

21. A semiconductor device comprising a semiconductor element and the cured multilayer resin sheet according to any one of claims 9 to 16, the cured multilayer resin sheet being positioned on the semiconductor element.
